# EUROPÄISCHE PATENTSCHRIFT

(11) **EP 2 245 667 B1**
(45) Veröffentlichungstag und Bekanntmachung des Hinweises auf die Patenterteilung: **09.05.2018**
(21) Anmeldenummer: 09714749.0
(22) Anmeldetag: 25.02.2009
(51) Int. Cl.: H01L 33/62, H01L 33/08, H01L 33/38, H01L 27/15

(54) **MONOLITHISCHER, OPTOELEKTRONISCHER HALBLEITERKÖRPER UND VERFAHREN ZUR HERSTELLUNG EINES SOLCHEN**
MONOLITHIC, OPTOELECTRONIC SEMI-CONDUCTOR BODY AND METHOD FOR THE PRODUCTION THEREOF
COMPOSANT SEMICONDUCTEUR OPTOÉLECTRONIQUE MONOLITHIQUE ET PROCÉDÉ DE FABRICATION

(30) Priorität: 29.02.2008 DE 102008011848; 31.03.2008 DE 102008016525
(43) Veröffentlichungstag der Anmeldung: 03.11.2010
(73) Patentinhaber: OSRAM Opto Semiconductors GmbH, 93055 Regensburg (DE)
(72) Erfinder: ENGL, Karl, 93080 Niedergebraching (DE); SINGER, Frank, 93128 Regenstauf (DE); RODE, Patrick, 93051 Regensburg (DE); HÖPPEL, Lutz, 93087 Alteglofsheim (DE); STRASSBURG, Martin, 93105 Tegernheim (DE)
(74) Vertreter: Epping - Hermann - Fischer
(86) Internationale Anmeldenummer: PCT/DE2009/000267
(87) Internationale Veröffentlichungsnummer: WO 2009/106063

(56) Entgegenhaltungen:
- WO-A-01/47039
- US-A- 5 798 691
- US-A- 5 952 681
- US-A1- 2006 113 548
- US-A1- 2006 163 589
- US-A1- 2007 090 377
- US-A1- 2007 131 958
- US-A1- 2007 284 598

## Beschreibung

Die Erfindung betrifft einen monolithischen optoelektronischen Halbleiterkörper sowie ein Verfahren zur Herstellung eines optoelektronischen Halbleiterkörpers.

Die Druckschriften US 2006/113548 A1, US 2007/0284598 A1, US 2006/163589 A1, US 2007/090377 A1, US 5,952,681 A, WO 01/47039 A1 und US 2007/131958 A1 zeigen optoelektronische Halbleiterbauelemente.

Optoelektronische Halbleiterkörper, welche in einem Betrieb eine elektromagnetische Strahlung emittieren, werden für eine Vielzahl unterschiedlicher Lichtanwendungen eingesetzt. Derartige Halbleiterkörper bieten sich vor allem dann an, wenn eine hohe Lichtausbeute auf einen geringen Raum erforderlich ist. Beispiele für die Verwendung von optoelektronischen Halbleiterkörpern mit einer hohen Lichtausbeute finden sich in Projektionsanwendungen und auch in Automotive-Bereichen. Dort werden sie unter anderem für Frontscheinwerfer eingesetzt.

Bei derartigen Lichtanwendungen soll neben einer hohen Lichtausbeute auch eine möglichst gleichmäßige Lichtabstrahlung gewährleistet sein. Zudem soll der optoelektronische Halbleiterkörper skalierbar ausgeführt sein, sodass die Lichtstärke variabel durch Hinzuschalten beziehungsweise Wegschalten einzelner lichtemittierender Elemente skalierbar ist.

Insofern besteht also das Bedürfnis, einen optoelektronische Halbleiterkörper anzugeben, der gegenüber herkömmlichen Beleuchtungsmitteln mit einer verbesserten Effizienz hinsichtlich Lichtausbeute und Abstrahlcharakteristik bei gleichzeitig höherer Ansteuerflexibilität ausgebildet sind.

Diese Aufgaben werden durch einen optoelektronischen Halbleiterkörper sowie durch ein Verfahren zur Herstellung eines solchen gemäß den unabhängigen Patentansprüchen gelöst. Ausgestaltungen und Weiterbildungen der Erfindung sind jeweils Gegenstand der Unteransprüche, deren Offenbarungsgehalt hiermit ausdrücklich in die Beschreibung mit aufgenommen wird.

In einem Ausführungsbeispiel umfasst ein optoelektronischer Halbleiterkörper eine Halbleiterschichtenfolge, die in wenigstens zwei elektrisch voneinander isolierten Teilsegmente unterteilt ist. Die Halbleiterschichtenfolge weist eine erste Hauptseite, eine zweite Hauptseite sowie in jedem Teilbereich eine zur Erzeugung elektromagnetischer Strahlung geeignete aktive Schicht auf. In der Ausführungsform ist die erste Hauptseite der Halbleiterschichtenfolge zur Emission von in der aktiven Schicht erzeugter elektromagnetischer Strahlung vorgesehen.

Die aktive Schicht kann hierbei einen pn-Übergang, eine Doppelheterostruktur, einen Einfachquantentopf- (SQW, single quantum well) oder eine Mehrfachquantentopfstruktur (MQW, multi quantum well) zur Strahlungserzeugung aufweisen. Die Bezeichnung Quantentopfstruktur entfaltet keinerlei Bedeutung hinsichtlich der Dimensionalität der Quantisierung. Sie umfasst im Allgemeinen unter anderem Quantentröge, Quantendrähte, Quantenflächen sowie Quantenpunkte, und jede Kombination dieser Strukturen. Ihre Dimensionalität kann somit von 0 Dimensionen im Fall von Quantenpunkten bis hin zu 3 Dimensionen im Fall von Quantentöpfen umfassen. Beispiele für Mehrfachquantentopfstrukturen sind in den Druckschriften WO 01/39282, US 5,831,277, US 6,172,382 sowie in der US 5,684,309 beschrieben.

Der optoelektronische Halbleiterkörper umfasst weiterhin einen ersten elektrischen Kontakt, einen zweiten elektrischen Kontakt sowie zumindest einen dritten elektrischen Kontakt. Eine erste auf der zweiten Hauptseite benachbart angeordnete Leitungsebene kontaktiert ein erstes der wenigstens zwei Teilsegmente der unterteilten Halbleiterschichtenfolge und den ersten elektrischen Kontakt. Sie stellt somit eine Verbindung zwischen dem ersten der wenigstens zwei Teilsegmente und dem ersten elektrischen Kontakt her. Eine zweite der zweiten Hauptseite benachbart angeordnete Leitungsebene kontaktiert den zweiten Kontakt sowie ein zweites der wenigstens zwei Teilsegmente elektrisch. Schließlich umfasst der optoelektronische Halbleiterkörper eine dritte, der zweiten Hauptseite benachbart angeordnete Leitungsebene. Diese verbindet das erste und zweite Teilsegment der Halbleiterschichtenfolge elektrisch zur Erzeugung elektromagnetischer Strahlung miteinander und kontaktiert darüber hinaus den dritten Kontakt. Gemäß der Erfindung sind somit neben mindestens drei Kontakten auf einer Oberfläche des Halbleiterkörpers auch wenigstens drei Leitungsebenen vorgesehen, die mit jeweils einem der Kontakte elektrisch verbunden sind. Die drei Leitungsebenen liegen der ersten Hauptseite der Halbleiterschichtenfolge abgewandt. Eine der wenigstens drei Leitungsebenen verbindet darüber hinaus das erste und zweite Teilsegment elektrisch miteinander zur Erzeugung elektromagnetischer Strahlung. Damit wird eine Serienschaltung zwischen der aktiven Schicht des ersten und zweiten Teilsegments realisiert. Die aktiven Schichten der beiden Teilsegmente werden daher über die dritte Leitungsebene derart miteinander verbunden, dass sie eine Serienschaltung bilden. Dadurch wird erreicht, dass der optoelektronische Halbleiterkörper in einem Betrieb einen deutlich geringeren Stromfluss aufweist, und über diese eine größere Spannung abfällt.

Der optoelektronische Halbleiterkörper nach dem vorgeschlagenen Prinzip kann somit spannungsgetrieben bei gleichzeitig niedrigen Strömen gespeist werden. Dadurch lassen sich beispielsweise aufwändige Treiberstufen sowie Hochstromquellen durch entsprechende Hochspannungsquellen ersetzen, welche leichter eingesetzt werden können. Durch den zusätzlichen dritten Kontakt, welcher die die beiden Teilsegmente verbindende Leitungsebene kontaktiert, wird darüber hinaus eine Einzelansteuerung der jeweiligen Teilsegmente möglich. Jedes Teilsegment des optoelektronischen Halbleiterkörpers kann somit einzeln angesteuert werden. Ebenso ist eine gemeinsame Ansteuerung beider Teilsegmente über die gebildete Serienschaltung möglich. Dadurch lässt sich die Lichtausbeute des optoelektronischen Halbleiterkörpers variieren.

Durch die Ausbildung von Leitungsebenen auf der der ersten Hauptseite abgewandten Seite wird zudem die Abstrahlcharakteristik auf der ersten Hauptseite der Halbleiterschichtenfolge nur unwesentlich verändert, da Kontaktierung und Zuführungen nicht mehr über diese Seite geführt werden müssen. Die einzelnen Teilsegmente der Halbleiterschichtenfolge erreichen daher eine gleichmäßigere Abstrahlcharakteristik. Zweckmäßigerweise ist der Halbleiterkörper monolithisch ausgebildet, das heißt er umfasst lediglich einen Körper, in dem alle Leitungsebenen, sowie aktive Schichten integriert sind und während der Herstellung nacheinander implementiert werden. Dies erlaubt eine großflächige Herstellung über den gesamten Wafer hinweg, einschließlich einer Ausbildung der aktiven Schichten und der Leitungsebenen auf einem gemeinsamen Substrat.

In einer Ausgestaltung ist der Halbleiterkörper ein Dünnfilm-Leuchtdiodenchip. Insbesondere weist er an seiner Rückseite ein Trägersubstrat auf. Bei einer Ausgestaltung sind die verschiedenen Leitungsebenen zumindest stellenweise zwischen der Halbleiterschichtenfolge und dem Trägersubstrat angeordnet.

Ein Dünnfilm-Leuchtdiodenchip zeichnet sich durch mindestens eines der folgenden charakteristischen Merkmale aus:
- an einer zu einem Trägerelement, insbesondere dem Trägersubstrat, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-Leuchtdiodenchip weist ein Trägerelement auf, bei dem es sich nicht um das Wachstumssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 20 *µ*m oder weniger, insbesondere im Bereich von 10 *µ*m oder weniger auf;
- die Halbleiterschichtenfolge ist frei von einem Aufwachssubstrat. Vorliegend bedeutet "frei von einem Aufwachssubstrat", dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Grundprinzip eines Dünnfilm-Leuchtdiodenchips ist beispielsweise in der Druckschrift I. Schnitzer et al., Appl. Phys. Lett. 63 (16) 18. Oktober 1993, Seiten 2174 - 2176 beschrieben, deren Offenbarungsgehalt insofern hiermit durch Rückbezug aufgenommen wird. Beispiele für Dünnfilm-Leuchtdiodenchips sind in den Druckschriften EP 0905797 A2 und WO 02/13281 A1 beschrieben, deren Offenbarungsgehalt insofern hiermit ebenfalls durch Rückbezug aufgenommen wird.

Ein Dünnfilm-Leuchtdiodenchip ist in guter Näherung ein Lambert'scher Oberflächenstrahler und eignet sich von daher beispielsweise gut für die Anwendung in einem Scheinwerfer, etwa einem Kraftfahrzeugscheinwerfer.

In einer Weiterbildung umfasst der optoelektronische Halbleiterkörper in seinem ersten Teilsegment eine erste Teilschicht und eine durch die aktive Schicht getrennte zweite Teilschicht. Das wenigstens eine zweite Teilsegment weist ebenfalls eine erste Teilschicht und eine durch die aktive Schicht getrennte zweite Teilschicht auf. Die dritte Leitungsebene ist nun derart ausgeführt, dass sie die erste Teilschicht des ersten Teilsegments und die zweite Teilschicht des zweiten Teilsegments miteinander elektrisch leitend verbindet. Somit wird beispielsweise eine n-dotierte Teilschicht des ersten Teilsegments mittels der dritten Leitungsebene mit einer p-dotierten Teilschicht des zweiten Teilsegments elektrisch leitend verbunden. Dadurch bildet sich eine Serienschaltung aus den beiden aktiven Teilschichten aus.

Zu diesem Zweck kann wenigstens eines der Teilsegmente einen Durchbruch umfassen, welcher durch die aktive Schicht des Teilsegments verläuft und die der ersten Hauptseite zugewandte Teilschicht des Teilsegments kontaktiert. Dieser Durchbruch kann zylinderförmig, rund, aber auch grabenförmig sein beziehungsweise jede beliebige geometrische Form aufweisen. Durch die Verwendung mehrerer Durchbrüche innerhalb des Teilsegments kann eine bessere laterale Stromverteilung in der der ersten Hauptseite zugewandten Teilschicht des Teilsegments erreicht werden. Dadurch wird die Abstrahlcharakteristik und die Lichtausbeute weiter verbessert.

In einer anderen Ausführungsform weist der optoelektronische Halbleiterkörper einen Graben auf, der mit einem isolierenden Material gefüllt sein kann. Der Graben kann im Wesentlichen senkrecht zur aktiven Schicht der jeweiligen Teilsegmente verlaufen und das ersten Teilsegment von dem wenigstens einen zweiten Teilsegment trennen. Die Breite der Gräben kann im Bereich von wenigen Mikrometern liegen. Vorzugsweise durchdringt der Graben zumindest den Bereich der aktiven Schicht der jeweiligen Teilsegmente, in dem eine Rekombination der Ladungsträger und damit die Erzeugung elektromagnetischer Strahlung erfolgen.

Alternativ kann der Graben senkrecht durch einen großen Bereich der Halbleiterschichtenfolge verlaufen und damit die Halbleiterschichtenfolge auch in die jeweiligen Teilsegmente unterteilen. In dieser Ausführungsform werden Leckströme zwischen den einzelnen Teilsegmenten verringert. Zudem kann der Graben auch senkrecht durch wenigstens eine der jeweiligen Leitungsebenen gehen und diese durchtrennen.

Vorteilhafterweise ist die Licht emittierende erste Hauptseite der Halbleiterschichtenfolge und des elektronischen Halbleiterkörpers frei von elektrischen Kontaktflächen. Dadurch wird eine Abschattung beziehungsweise Absorption eines Teils der von der aktiven Teilschicht im Betrieb emittierten elektromagnetischen Strahlung durch die Kontaktstellen reduziert.

In einer anderen Ausgestaltung der Erfindung sind Kontaktpads benachbart der ersten Hauptseite des Halbleiterkörpers neben dem strahlungsemittierenden Bereich ausgeführt. In dieser Ausführung umfasst der optoelektronische Halbleiterkörper einen von den wenigstens zwei Teilsegmenten elektrisch isolierten Außenbereich, der benachbart zu zumindest einem der wenigstens zwei Teilsegmente angeordnet ist. Auf einer der ersten Hauptseite zugewandten Seite weist dieser Außenbereich ein Kontaktpad aus dem ersten, zweiten und dritten Kontakt auf. Der Kontaktpad ist mit der jeweiligen Leitungsebene elektrisch verbunden.

In einer weiteren Ausgestaltung kann zumindest eine Leitungsebene mit einer leitenden Spiegelschicht ausgestaltet sein, sodass von der aktiven Schicht emittierte elektromagnetische Strahlung in Richtung der zweiten Hauptseite hin in Richtung der ersten Hauptseite reflektiert wird. Dadurch wird die Abstrahlcharakteristik weiter verbessert.

In einer anderen Weiterbildung ist zwischen der Halbleiterschichtenfolge und den einzelnen Leitungsebenen sowie den entsprechenden Kontakten der Leitungsebenen zu der Halbleiterschichtenfolge wenigstens stellenweise eine Spiegelschicht angeordnet. Diese kann halbleitend aber auch elektrisch isolierend sein. Im letzteren Fall kann sie eine Mehrzahl von Öffnungen aufweisen, durch welche die Leitungsebenen die Halbleiterschichtenfolge in den jeweiligen Teilsegmenten elektrisch kontaktieren. Die Spiegelschicht kann darüber hinaus als laterale Stromverteilungsschicht dienen, um eine Stromeinkopplung in die Halbleiterschichtenfolge zu verbessern. Beispielsweise kann eine Stromaufweitungsschicht hierzu ein leitendes Oxid umfassen. Zudem kann sie als Spiegelschicht beispielsweise mit Silber ausgebildet sein und somit neben einem geringen lateralen Widerstand auch gute Reflexionseigenschaften aufweisen.

In einer Weiterbildung ist die aktive Schicht der Halbleiterschichtenfolge durch mehrere übereinander gestapelte aktive Teilschichten gebildet. Beispielsweise kann die aktive Schicht eine Doppelheterostruktur oder ein Mehrfach-Quantum-Well beinhalten. Darüber hinaus ist es möglich, in jedem Teilbereich der Halbleiterschichtenfolge unterschiedliche aktive Schichten vorzusehen. Diese können unterschiedlich dotiert sein, aber auch unterschiedliche Materialien beinhalten, sodass bei einer Rekombination von Ladungsträgern elektromagnetische Strahlung unterschiedlicher Wellenlänge emittiert wird.

Zur Verbesserung der Emission kann die erste Hauptseite der Halbleiterschichtenfolge strukturiert sein. Ebenso ist es möglich, auf der ersten Hauptseite ein zusätzliches Konversionsmaterial aufzubringen, um so die emittierte elektromagnetische Strahlung in eine zweite Strahlung unterschiedlicher Wellenlänge zu verwandeln. Dies erlaubt es, unterschiedliche. Farbeindrücke zu realisieren und auch Mischfarben erzeugen zu können. Bei einem entsprechend geeigneten Konversionsmaterial sowie bestimmten Materialsystemen für die aktive Schicht der beiden Teilsegmente der Halbleiterschichtenfolge kann dadurch weißes Licht beispielsweise für Frontscheinwerfer oder Projektionssysteme erzeugt werden.

Die einzelnen Teilsegmente der Halbleiterschichtenfolge können flächig nebeneinander angeordnet werden. Beispielsweise können sie quadratisch in Form einer x • x-Matrix angeordnet sein, wobei x eine natürliche Zahl > 2 ist. Alternativ können sie auch zur Bildung einer rechteckigen Struktur verwendet werden, beispielsweise in Form einer x • y-Matrix. In beiden Fällen wird so die Matrix aus den Teilsegmenten als Halbleiterkörper auf einem gemeinsamen Träger gefertigt.

Die Ansteuerung durch die Kontaktebene mit den verschiedenen Leitungsebenen auf der der ersten Hauptseite abgewandten Seite der Halbleiterschichtenfolge ist nicht auf zwei Teilsegmente beschränkt. Durch entsprechende zusätzliche Leitungsebenen können mehrere Teilsegmente unter Bildung einer Serienschaltung miteinander verbunden werden. Durch zusätzliche Kontaktelemente, welche die einzelnen Leitungsebenen kontaktieren, ist eine selektive Ansteuerung einzelner Teilsegmente der Halbleiterschichtenfolge möglich. Eine Verschaltung kann extern durch einen Mikroprozessor oder eine andere integrierte Schaltung erfolgen. Diese kann auch die benötigten Treiberstufen umfassen.

Ein weiterer Aspekt der Erfindung betrifft ein Verfahren zur Herstellung eines optoelektronischen Halbleiterkörpers. Bei diesem erfolgt ein epitaktisches Aufwachsen einer Halbleiterschichtenfolge auf einem Aufwachssubstrat, wobei die Halbleiterschichtenfolge eine zur Erzeugung von elektromagnetischer Strahlung geeignete aktive Schicht aufweist. Des Weiteren wird ein erstes Teilsegment und wenigstens ein hiervon elektrisch isolierter zweiter Teilbereich der Halbleiterschichtenfolge definiert, die zu einer Emission elektromagnetischer Strahlung in Richtung auf eine erste Hauptseite vorgesehen sind.

Es wird eine erste Leitungsebene benachbart zu einer der ersten Hauptseite abgewandten Seite der Halbleiterschichtenfolge derart ausgebildet, dass sie die aktive Schicht des ersten Teilsegments kontaktiert. Eine zweite Leitungsebene wird benachbart zu der der ersten Hauptseite abgewandten Seite der Halbleiterschichtenfolge ausgebildet und kontaktiert die aktive Schicht des wenigstens einen zweiten Teilsegments.

Schließlich wird wenigstens eine dritte Leitungsebene an der der ersten Hauptseite abgewandten Seite der Halbleiterschichtenfolge ausgeführt. Diese kontaktiert die aktive Schicht des ersten Teilsegments und die aktive Schicht des wenigstens einen zweiten Teilsegments. Ferner koppelt die dritte Leitungsebene die aktiven Schichten der wenigstens zwei Teilsegmente unter Bildung einer Serienschaltung miteinander.

Des weiteren umfasst das erfindungsgemäße Verfahren ein Ausbilden einer ersten Kontaktstelle, die mit der ersten Leitungsebene verbunden ist, ein Ausbilden einer zweiten Kontaktstelle, die mit der zweiten Leitungsebene verbunden ist, sowie ein Ausbilden wenigstens einer dritten Kontaktstelle, die mit der wenigstens einen dritten Leitungsebene verbunden ist.

Bei dem vorgeschlagenen Verfahren wird ein Halbleiterkörper gebildet, dessen zwei Teilsegmente jeweils eine aktive Schicht zur Erzeugung und Emission elektromagnetischer Strahlung aufweisen. Durch die auf der gegenüberliegenden Seite der ersten Hauptseite der Halbleiterschichtenfolge angeordneten Leitungsebenen, welche zusammengefasst eine Kontaktebene bilden, wird eine einzelne Ansteuerung der aktiven Schicht der jeweiligen Teilsegmente erreicht. Die zusätzliche dritte Leitungsebene mit der Verbindung sowohl zu der dritten Kontaktstelle als auch zu den aktiven Schichten der beiden Teilsegmente der Halbleiterschichtenfolge erlaubt eine selektive Ansteuerung jeweils eines Teilsegments als auch eine gemeinsame Ansteuerung beider Teilsegmente durch die mit der dritten Leitungsebene ausgebildete Serienschaltung der beiden Teilsegmente.

In einer Ausgestaltung der Erfindung wird neben der Halbleiterschichtenfolge zusätzlich eine Spiegelschicht auf einer der ersten Hauptseite abgewandten Seite der Halbleiterschichtenfolge aufgewachsen. Diese Spiegelschicht kann durch ein elektrisch isolierendes Material gebildet werden. Alternativ ist auch ein leitendes Material möglich, wobei zwischen der Spiegelschicht und der Halbleiterschichtenfolge eine zusätzliche isolierende Zwischenschicht zur elektrischen Entkopplung vorhanden sein kann. In einer alternativen Ausgestaltung wird wenigstens eine der drei Leitungsebenen mit einer entsprechenden Spiegelschicht ausgebildet. Beispielsweise können die Leitungsebenen durch ein stark reflektierendes Metall gebildet werden.

In einer Ausführungsform des erfindungsgemäßen Verfahrens wird eine Spiegelschicht zusätzlich oder in Form der Leitungsebenen auf der der ersten Hauptseite abgewandten Seite der Halbleiterschichtenfolge aufgebracht, sodass wenigstens 50 % der Fläche der Halbleiterschichtenfolge auf der der ersten Hauptseite abgewandten Seite verspiegelt ist. Das Reflexionsvermögen einer derartigen Spiegelschicht kann über 50 % liegen und insbesondere im Bereich zwischen 50 und 99,9 % sein.

Das epitaktische Aufwachsen erfolgt nach einem Bereitstellen eines Aufwachssubstrates durch Aufwachsen einer ersten Teilschicht mit einem ersten Dotiertyp und einem anschließenden Aufwachsen einer zweiten Teilschicht mit einem zweiten Dotiertyp auf der ersten Teilschicht. Durch die unterschiedlichen Dotiertypen wird zwischen der ersten und der zweiten Teilschicht die aktive Schicht ausgebildet, die einen so genannten pn-Übergang darstellt. Hierbei kann die erste Teilschicht, also die der ersten Hauptseite benachbarte Teilschicht eine n-dotierte Teilschicht sein. Die der ersten Hauptseite abgewandte zweite Teilschicht ist dementsprechend p-dotiert.

Zusätzlich können auf den Teilschichten Stromaufweitungsschichten gebildet werden, die einen besonders geringen lateralen Flächenwiderstand aufweisen. Zweckmäßigerweise kontaktieren die Leitungsebenen die Stromaufweitungsschichten. Beispielsweise kann nach dem Aufwachsen einer zweiten Teilschicht auf der ersten Teilschicht auf der zweiten Teilschicht eine Stromaufweitungsschicht gebildet werden, die durch zumindest die wenigstens eine dritte Leitungsebene kontaktiert wird. In einer Ausbildung des erfindungsgemäßen Verfahrens kann die Stromaufweitungsschicht zusätzlich mit einer verspiegelten Schicht gebildet sein.

Erste, zweite und dritte Leitungsebenen werden durch entsprechende Isolationsschichten voneinander getrennt. In einem Ausführungsbeispiel umfasst das Verfahren ein Aufwachsen von Leitungsebenen und anschließendes Strukturieren derselben. Anschließend werden isolierende Materialien auf der strukturierten Leitungsebene aufgebracht. Ebenso kann auch ein isolierendes Material auf der Halbleiterschichtenfolge aufgewachsen und anschließend das isolierende Material strukturiert werden.

Für das Ausbilden wenigstens einer der ersten, zweiten und zumindest einen dritten Leitungsebene wird in einer Weiterbildung des vorgeschlagenen Verfahrens Durchbrüche durch die aktive Schicht in wenigstens einem der wenigstens zwei Teilsegmente ausgebildet. Die Seitenwände des Durchbruchs werden mit einem isolierenden Material versehen, um einen Kurzschluss zu vermeiden. Dies kann beispielsweise durch Abscheiden eines isolierenden Materials auf den Seitenwänden des Durchbruchs erfolgen. Alternativ können die Seitenwände des Durchbruchs auch oxidiert werden, um eine Isolationsschicht zu bilden. Anschließend wird der Durchbruch mit einem leitenden Material gefüllt, welches die wenigstens eine der Leitungsebenen kontaktiert. Auf diese Weise werden durch die Leitungsebenen Teilschichten kontaktiert, die der ersten Hauptseite der Halbleiterschichtenfolge zugewandt sind.

In einer weiteren Ausbildung erfolgt die Fertigung der ersten, zweiten und dritten Kontaktstelle gleichzeitig mit dem Ausbilden der mit den Kontaktstellen verbundenen Leitungsebenen. Mit anderen Worten wird somit ein Teilbereich des Halbleiterkörpers definiert, und auf diesen die Leitungsebene ausgebildet. Dieser Teilbereich bildet später die entsprechende Kontaktstelle und ist mit der Leitungsebene direkt verbunden.

Zur weiteren Ausgestaltung des Verfahrens wird nach dem epitaktischen Aufwachsen auf dem Aufwachssubstrat insbesondere nach der Herstellung der Kontaktierungsebene mit den einzelnen Leitungsebenen das Aufwachssubstrat abgenommen. Anschließend wird die so hergestellte Schichtenfolge auf einem Trägersubstrat aufgebracht. Dies erfolgt derart, dass das Trägersubstrat zu der dritten Leitungsebene benachbart ist. Das Abnehmen des Aufwachssubstrates kann durch entsprechendes "Absprengen" mittels eines Lasers erfolgen.

In einer Weiterbildung des Verfahrens werden dann die vorher definierten Teilsegmente durch einen selektiven Trennprozess voneinander elektrisch isoliert. Beispielsweise kann der Trennprozess mit einem chemischen Ätzprozess durchgeführt werden, in dem Graben entlang der Trennungslinie der jeweiligen vorher definierten Teilsegmente geätzt werden. Dieser Graben erreicht durch die Schichtenfolge bis hin zur Kontaktebene. Der Graben kann mit einem elektrisch isolierenden Material aufgefüllt werden, jedoch auch freiliegend sein.
Im Folgenden wird die Erfindung anhand verschiedener Ausgestaltungen und Ausführungsformen unter Bezugnahme auf die Zeichnung im Detail erläutert. Es zeigen:
- Figur 1: eine schematische Draufsicht einer ersten Ausführungsform eines optoelektronischen Halbleiterkörpers nach dem vorgeschlagenen Prinzip,
- Figur 2A: eine schematische Querschnittsansicht der Ausführungsform gemäß Figur 1 entlang der I-I'-Ebene,
- Figur 2B: eine schematische Querschnittsansicht der Ausführungsform gemäß Figur 1 entlang der II-II'-Ebene,
- Figur 3: eine Querschnittsdarstellung einer zweiten Ausführungsform mit rückseitig angeordneten Kontakten,
- Figur 4A, 4B: schematische Schnittdarstellungen gemäß einer dritten Ausführungsform,
- Figur 4C, 4D: Ersatzschaltbild der Ausführungsformen in den Figuren 4A, 4B,
- Figur 4E, 4F: Draufsichten über einen optoelektronischen Halbleiterkörper unterteilt in mehrere Teilsegmente korrespondierend zu den Schnittdarstellungen und den Ersatzschaltbildern der Figuren 4A bis 4D,
- Figur 5: eine Ausführungsform optoelektronischer Halbleiterkörper in einer Lichtanwendung,
- Figur 6: eine Querschnittsdarstellung einer vierten Ausführungsform,
- Figur 7A bis 7J: schematische Draufsichten auf die ersten Ausführungsform des optoelektronischen Halbleiterkörpers in verschiedenen Stufen des Herstellungsprozesses.

In den verschiedenen Ausführungsbeispielen sind die Größenverhältnisse der dargestellten Elemente grundsätzlich nicht als maßstabsgerecht zu betrachten. Vielmehr können einzelne Elemente etwa Schichten zum besseren Verständnis und/oder zur besseren Darstellbarkeit übertrieben groß beziehungsweise dick dargestellt sein. Wirkungs- beziehungsweise funktionsgleiche Bauelemente tragen innerhalb der Figuren die gleichen Bezugszeichen.

Alle hier dargestellten Ausführungen und auch die Herstellungsverfahren beziehen sich auf ein monolithisches Bauelement. Unter dem Begriff monolithisch wird eine Herstellung verstanden, bei dem einzelne Schichten nicht getrennt voneinander hergestellt werden. Vielmehr erfolgt ein Abscheiden oder ausbilden von Schichten, unabhängig davon, welche Funktion sie erfüllen, auf einer in einem vorangegangenen Prozessschritt hergestellten Schicht. Dadurch wird in aufeinanderfolgenden Schritten ein Halbleiterkörper nach dem vorgeschlagenen Prinzip hergestellt.

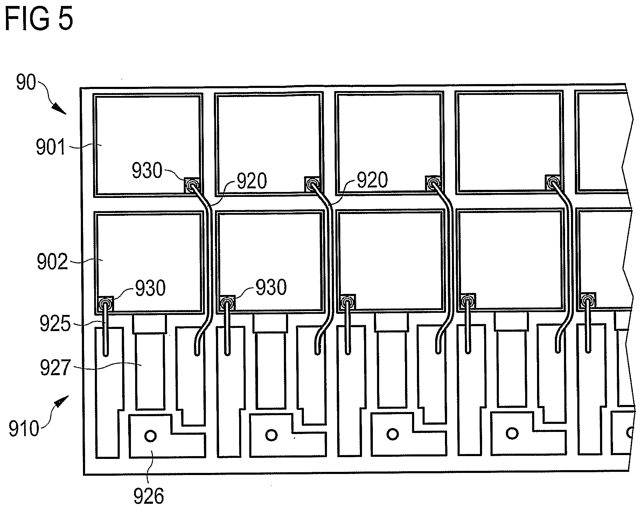

Figur 5 zeigt ein Ausführungsbeispiel eines monolithischen optoelektronischen Halbleiterkörpers mit einzelnen Teilsegmenten angeordnet in einer 2 • x-Matrix in einer Anwendung als Scheinwerfer. Dargestellt sind 2 • 4 vollständige Segmente, wobei die Anordnung nach rechts fortgesetzt wird. In der Ausführungsform sind verschiedene Teilsegmente 901, 902 im Wesentlichen quadratisch vorgesehen. Diese emittieren in einem Betrieb der Schaltung jeweils elektromagnetische Strahlung einer Wellenlänge. Durch eine Ansteuerung der einzelnen Teilsegmente 901, 902 kann die Strahlintensität des Lichtsystems selektiv gesteuert werden.

Zur Kontaktierung enthält jedes Teilsegment 901 und 902 einen eckförmigen Außenbereich 930, der mit einem Kontaktpad versehen ist. Das Kontaktpad ist über einen Bonddraht 920 beziehungsweise 925 an ein Kontaktpanel in einem Außenbereich 910 geführt. Die Bonddrähte 920 und 925 verbinden das jeweilige Kontaktpanel über das Kontaktpad mit der n-dotierten Schicht des jeweiligen Teilsegments 901, 902. Zur Kontaktierung der p-dotierten Teilschichten der beiden Teilsegmente 901, 902 sind zwei weitere Kontaktpanele 926, 927 im Außenbereich 910 vorgesehen.

Durch die Kontaktstellen 930 in den jeweiligen Ecken der Teilsegmente 901 beziehungsweise 902 wird in einem Betrieb der Anordnung in diesen Stellen eine Abschattung erzeugt. Dadurch ergibt sich eine ungleichförmige Lichtabstrahlcharakteristik der einzelnen Teilsegmente, die auch bei starker Leuchtkraft noch deutlich zu erkennen ist. Der Abschattungseffekt tritt deutlicher hervor, wenn die Bonddrähte 920 nicht, wie hier dargestellt, in den isolierten Bereichen zwischen zwei Teilsegmenten entlang geführt sind, sondern die Segmente überlappen. Gleichzeitig wird in der dargestellten Ausführung durch die relativ großen Zwischenbereiche eine Lichteffizienz und Ausbeute verringert beziehungsweise der für die Implementierung erforderliche Platz vergrößert.

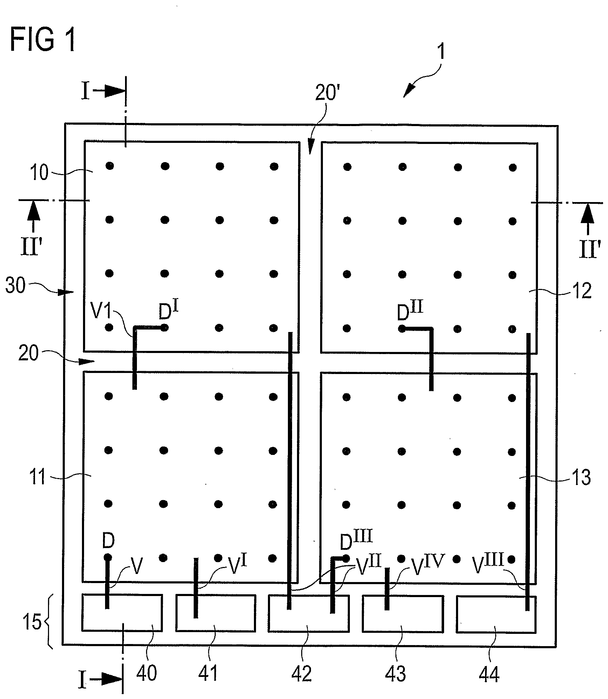

Figur 1 zeigt demgegenüber eine schematische Draufsicht einer Ausführungsform nach dem vorgeschlagenen Prinzip. In dem Ausführungsbeispiel ist ein monolithischer optoelektronischer Halbleiterkörper mit vier lichtemittierenden Teilsegmenten 10 bis 13 in Form einer 2 • 2-Matrix ausgeführt. Die einzelnen Teilsegmente sind elektrisch durch isolierende Gräben 20, 20' voneinander sowie von einem Außenbereich 15 getrennt. Die Isolierung 20, 20' kann gegenüber der Ausführungsform gemäß Figur 5 eine deutlich geringere Dicke aufweisen, da er lediglich zur elektrischen Isolation der Teilsegmente 10 bis 13 dient. Kontaktelemente beziehungsweise Bonddrähte werden jedoch nicht mehr darüber geführt.

In dem Außenbereich 15 sind insgesamt 5 Kontaktpads 40 bis 44 angeordnet. Diese sind, wie im Weiteren noch erläutert, mit einzelnen Leitungsebenen unterhalb der aktiven Schicht der einzelnen Teilsegmente 10 bis 13 verbunden und kontaktieren diese. Die Leitungsebenen stellen wiederum den elektrischen Kontakt zu den jeweiligen p- und n-Schichten der Halbleiterschichtenfolge der einzelnen Teilsegmente 10 bis 13 her. Zusammengefasst bilden sie eine Kontaktebene, die der lichtemittierenden Hauptseite abgewandt ist.

Die Halbleiterschichtenfolge in den einzelnen Teilsegmenten 10 bis 13 basiert auf einem Halbleitermaterialsystem, welches je nach Anwendung unterschiedlich dotiert sein kann. Beispielsweise können so genannte III/V-Verbindungs-Halbleiter oder auch II/VI-Verbindungs-Halbleiter verwendet werden. Die Halbleiterschichtenfolge 2 kann vorliegend eine Dicke zwischen 5 *µ*m und 7 *µ*m betragen.

Ein III/V-Verbindungs-Halbleitermaterial weist wenigstens ein Element aus der dritten Hauptgruppe, wie beispielsweise Al, Ga, In, und ein Element aus der V-Hauptgruppe, wie beispielsweise B, N, P, As, auf. Insbesondere umfasst der Begriff "III/V-Verbindungs-Halbleitermaterial" die Gruppe der binären, ternären oder quaternären Verbindungen, die wenigstens ein Element aus der dritten Hauptgruppe und wenigstens ein Element aus der fünften Hauptgruppe enthalten, insbesondere Nitrid- und Phosphid-Verbindungs-Halbleiter. Eine solche binäre, ternäre oder quaternäre Verbindung kann zudem beispielsweise ein oder mehrere Dotierstoffe sowie zusätzliche Bestandteile aufweisen. Zu den III/V-Verbindungs-Halbleitermaterialien gehören beispielsweise Nitrid-III-Verbindungs-Halbleitermaterial und Phosphid-III-Verbindungs-Halbleitermaterialien, etwa GaN, GaAs, und InGaAlP. Ebenso wird das Materialsystem AlGaN/GaN zu den oben genannten Verbindungshalbleitern gezählt.

Entsprechend weist ein II/VI-Verbindungs-Halbleitermaterial wenigstens ein Element aus der zweiten Hauptgruppe, wie beispielsweise Be, Mg, Ca, Sr, und ein Element aus der sechsten Hauptgruppe, wie beispielsweise O, S, Se, auf. Insbesondere umfasst ein II/VI-Verbindungs-Halbleitermaterial eine binäre, ternäre oder quaternäre Verbindung, die wenigstens ein Element aus der zweiten Hauptgruppe und wenigstens ein Element aus der sechsten Hauptgruppe umfasst. Eine solche binäre, ternäre oder quaternäre Verbindung kann zudem beispielsweise ein oder mehrere Dotierstoffe sowie zusätzliche Bestandteile aufweisen. Zu den II/VI-Verbindungs-Halbleitermaterialen gehören zum Beispiel ZnO, ZnMgO, CdS, CnCdS, MgBeO.

Abhängig von der gewünschten Wellenlänge oder dem gewünschten Wellenlängenspektrum können eine oder auch mehrere der oben genannten Verbindungen als Materialsystem für ein optoelektronisches Bauelement bereitgestellt werden.

Zur Kontaktierung ist das erste Kontaktpad 40 über eine unterhalb und hier durch die Verbindung V angedeutete Leitungsebene mit der der Hauptseite des Teilsegments 11 zugewandten Teilschicht verbunden. Dies ist durch die Verbindung V des Kontaktpads 40 zu dem Durchführungsloch D schematisch dargestellt. Das Kontaktpad 40 kontaktiert somit über die Leitungsebene die n-dotierte Teilschicht der Schichtenfolge des Teilsegments 11. Entsprechend ist das Kontaktpad 41 über eine weitere Leitungsebene hier schematisch durch die Verbindung V' mit der p-dotierten Teilschicht der aktiven Schichtenfolge des Teilsegments 11 elektrisch leitend verbunden. Des Weiteren ist diese Leitungsebene auch dazu vorgesehen, über weitere Durchbrüche D' die n-dotierte Teilschicht der aktiven Schichtenfolge des zweiten Teilsegments 10 zu kontaktieren.

Dies ist schematisch durch die Verbindung V' angedeutet, welche den p-dotierten Bereich der aktiven Schichtenfolge des ersten Teilsegments 11 über Durchbrüche D' mit dem n-dotierten Bereich der Schichtenfolge des zweiten Teilsegments 10 kontaktiert. Dadurch wird auch eine elektrische Verbindung zwischen der Kontaktfläche 41 über die Leitungsebene unter dem Teilbereich 11 hindurch zu der n-dotierten Teilschicht der aktiven Schichtenfolge des zweiten Teilsegments 10 kontaktiert.

Schließlich ist eine weitere dritte Leitungsebene V'' vorgesehen, welche von den anderen Leitungsebenen der Kontaktierungsebene isoliert ist und unterhalb der aktiven Schichtenfolge des Teilsegments 11 verläuft. Sie verbindet die p-dotierte Teilschicht der aktiven Schichtenfolge des Teilsegments 10 mit dem Kontaktpad 42. Somit ist auch für den zweiten Teilbereich 10 eine Kontaktierung der beiden Teilschichten gegeben, nämlich einerseits über die Leitungsebene V' mit dem Kontaktpad 41 und über eine weitere Leitungsebene V'' mit dem Kontaktpad 42.

Das Kontaktpad 42 ist zudem über Durchbrüche mit der n-dotierten Teilschicht der aktiven Schichtenfolge des Teilsegments 13 verbunden. Mit anderen Worten kontaktiert die Leitungsebene V'' die p-dotierte Teilschicht des Teilsegments 10 sowie die n-dotierte Teilschicht des Teilsegments 13 des optoelektronischen Bauelementes. Das Kontaktpad 43 ist über eine Leitungsebene dargestellt durch die Verbindung V^{IV} mit der p-dotierten Teilschicht des Teilsegments 13 elektrisch leitend verbunden. Gleichzeitig steht sie über diese Leitungsebene in Kontakt mit Durchbrüchen D'' im Teilbereich 12 des optoelektronischen Bauelementes. Die Durchbrüche D'' verbinden die n-dotierte Teilschicht der aktiven Schichtenfolge des Teilsegments 12 einerseits mit der Kontaktfläche 43 und andererseits über die Leitungsebene mit der p-dotierten Teilschicht der aktiven Schichtenfolge des Teilsegments 13. Eine letzte Leitungsebene schematisch dargestellt durch die Verbindung V^{III} verbindet die fünfte Kontaktfläche 44 mit der p-dotierten Teilschicht der aktiven Schichtenfolge des Teilsegments 12. Im vorliegenden Ausführungsbeispiel sind die Leitungsebenen der Kontaktebenen überlappend angeordnet. Sie können aber je nach Anwendung auch nebeneinander verlaufen.

Durch die Anordnungen der Leitungsebenen untereinander sowie der einzelnen Kontaktflächen und deren Verbindung zu den jeweiligen Leitungsebenen wird eine selektive Ansteuerung eines jeden einzelnen Teilsegments 10 bis 13 des optoelektronischen Halbleiterbauelementes 1 möglich. Ebenso können unter Bildung einer Serienschaltung jeweils zwei Teilsegmente zusammengefasst werden. Ebenso können alle vier Teilsegmente unter Bildung einer Serienschaltung im Betrieb genutzt werden. Die folgende Tabelle veranschaulicht die Verschaltung im Betrieb des optoelektronischen Halbleiterkörpers je nach gewünschter Betriebsart.

| Zu betreibende Segmente | Anzuschließende Kontakte |
|---|---|
| 10 | 41 mit n, 42 mit p |
| 11 | 40 mit n, 41 mit p |
| 12 | 43 mit n, 44 mit p |
| 13 | 42 mit n, 43 mit p |
| 10 und 11 | 40 mit n, 42 mit p |
| 12 und 13 | 42 mit n, 44 mit p |
| 10 bis 13 | 40 mit n, 44 mit p |

In der Tabelle bezeichnet "n" oder "p" den jeweiligen Ladungsträgertyp, der dem Kontaktpad zugeführt wird. Der pn-Übergang in der aktiven Schicht der Teilsegmente wird im Betrieb jeweils in Flussrichtung geschaltet. Daraus ergibt sich, dass das Kontaktpad 40, wenn überhaupt, immer mit "n", das Kontaktpad 44 immer mit "p" beaufschlagt wird. Die weiteren drei Kontaktpads 41 bis 43 werden je nach gewünschter Betriebsart entweder mit einem positiven Potential oder einem negativen Potential beaufschlagt und entsprechende Ladungsträger zugeführt.

Wenn beispielsweise im Betrieb eine Strahlungsemission lediglich des Teilsegments 10 erfolgen soll, wird an das Kontaktpad 41 ein negatives Potential (entspricht einer Zuführung von Elektronen) und an das Kontaktpad 42 ein entsprechend positives Potential (entspricht einer Zuführung von Löchern) angelegt, um die Diode des Teilsegments in Flussrichtung zu schalten. Über die Leitungsebene, dargestellt durch die Verbindung V^{I} und die im Teilbereich 10 vorhandenen Durchbrüche D' werden der n-dotierten Teilschicht und der p-dotierten Teilschicht über die zweite Leitungsebene V^{II} die entsprechenden Ladungsträger zugeführt. Da gleichzeitig der Teilbereich 11 über das Kontaktpad 41 in Sperrrichtung geschaltet ist, emittiert dieser keine Strahlung. Wenn hingegen die Teilsegmente 10 und 11 zur Strahlungserzeugung ausgewählt werden, müssen gemäß der Tabelle den Kontaktpads 40 und 42 an die entsprechende Spannung zugeführt werden.

Durch die hier vorgeschlagene Verdrahtungsebene können somit jedes Teilsegment einzeln, aber auch zwei Segmente paarweise miteinander in Serie verschaltet werden.

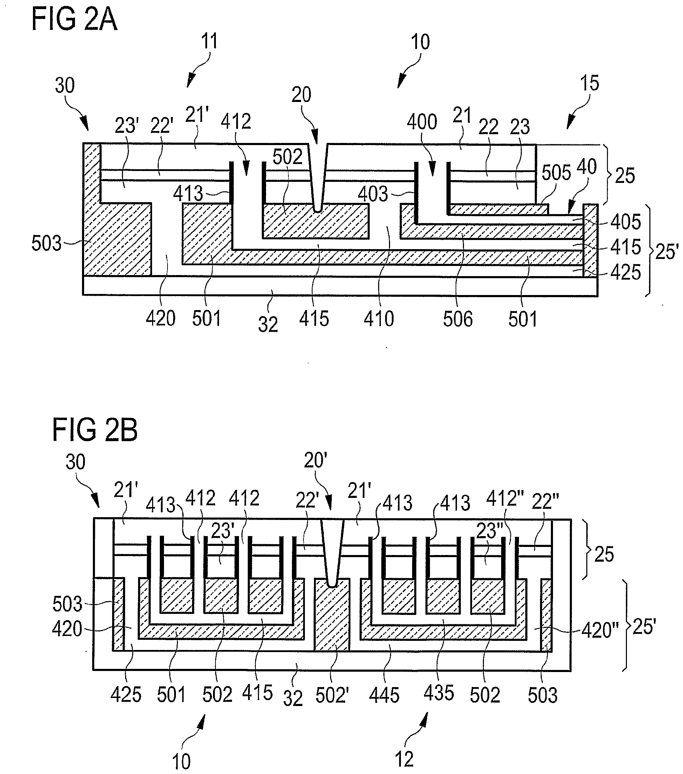

Figur 2A zeigt diesbezüglich eine Querschnittsansicht entlang der Achse I-I'. Die Halbleiterschichtenfolge 25 des optoelektronischen Halbleiterkörpers ist durch einen Graben 20 in die beiden Teilsegmente 10 beziehungsweise 11 unterteilt. Die Halbleiterschichtenfolge 25 umfasst eine der Abstrahlfläche zugewandte erste n-dotierte Teilschicht 21 in Teilsegment 10 beziehungsweise 21' im Teilsegment 11. Eine weitere Teilschicht 23, 23' ist p-dotiert und auf der der Abstrahlfläche abgewandten Seite aufgebracht. Durch die gemeinsame Anordnung der n-dotierten und p-dotierten Teilschichten 21, 21' und 23, 23' bildet sich im Teilbereich 10 ein erster pn-Übergang 22 und im Teilbereich 11 ein zweiter pn-Übergang 22' aus. In diesem pn-Übergang findet die Ladungsträgerrekombination unter Emission elektromagnetischer Strahlung statt. Durch den durchtrennenden Graben 20, der durch alle Teilschichten der Schichtenfolge 25 hindurchgeht, wird eine elektrische Isolation der beiden Teilsegmente 10 und 11 erzeugt und gleichzeitig Leckströme zwischen den beiden Teilsegmenten vermieden.

Zur Kontaktierung der n-dotierten Teilschicht 21 des ersten Teilsegments 10 ist ein Durchbruch 400 vorgesehen, dessen Seitenwände 403 mit einem elektrischen Material isoliert sind. Dadurch wird im Betrieb ein Kurzschluss und ein Stromfluss in die p-dotierte Schicht 23 vermieden. Der Durchbruch 400 reicht von der p-dotierten Teilschicht 23 durch den pn-Übergang 22 hindurch, bis zur n-dotierten Teilschicht 21. Darüber hinaus steht der Durchbruch 400 in elektrisch leitendem Kontakt mit einer ersten Leitungsebene 405. Diese ist von der p-dotierten Teilschicht 23 als auch von den weiteren Leitungsebenen durch eine Isolationsschicht 505 beziehungsweise 506 getrennt. Die Leitungsebene 405 führt wie dargestellt zu dem Kontaktpad 40, die im vorliegenden Fall durch einen Teilbereich der Leitungsebene 405 selbst gebildet ist. Somit kontaktiert das Kontaktpad 40 die n-dotierte Teilschicht 21 des ersten Teilsegments 10 über den Durchbruch 400 und die Leitungsebene 405.

Im dargestellten Ausführungsbeispiel ist eine zweite Leitungsebene 415 unterhalb der ersten Leitungsebene angeordnet und verläuft von dem hier nicht mehr dargestellten Kontaktpad 41 einerseits zu einer Kontaktierung 410 der p-dotierten Schicht 23 und zudem zu weiteren Durchbrüchen 412. Dieser ist Teil des zweiten Teilsegments 11 und kontaktiert die n-dotierte Teilschicht 21' der Schichtenfolge 25 des zweiten Teilsegments 11. Auch hier sind die Seitenwände über eine zusätzliche isolierende Schicht 413 von der aktiven Schicht 22' beziehungsweise der p-dotierten Teilschicht 23' getrennt. Unterhalb der zweiten Leitungsebene 415 und zur Trennung von der dritten Leitungsebene 425 ist eine Isolationsschicht 501 vorgesehen. Daneben trennt die Isolation 502 diese Leitungsebene auch von der p-dotierten Teilschicht 23' des zweiten Teilsegments 11.

Eine dritte Leitungsebene 425 verbindet schließlich den dritten Kontakt 42 gemäß der Draufsicht der Figur 1 und die p-dotierte Teilschicht des Teilsegments 11 über die Zuführung 420. Die dritte Leitungsebene ist auf einem isolierenden Substrat 32 aufgebracht und von der Isolation 503 und 501 umgeben.

Für den Betrieb der Anordnung der einzelnen Teilsegmente 10 beziehungsweise 11 wird im Folgenden der Stromfluss erläutert. In Flussrichtung geschaltet bei einem Betrieb lediglich des Teilsegments 10 werden das Kontaktpad 40 und damit die erste Leitungsebene 405 sowie die zweite Leitungsebene 415 mit einem entsprechenden Potential beaufschlagt. Der Strom fließt dann über die n-dotierte Teilschicht 22 in die p-dotierte Teilschicht 23, wobei die zugeführten Ladungsträger im pn-Übergang 22 des ersten Teilsegments rekombinieren und elektromagnetische Strahlung abgeben.

Für einen Betrieb lediglich des zweiten Teilsegments 11 wird der dort vorhandene pn-Übergang 22' in Flussrichtung geschaltet. Dies erfolgt durch Zuführung entsprechender Ladungsträger in der zweiten Leitungsebene 415 beziehungsweise der dritten Leitungsebene 425 über die entsprechenden Kontaktpads. Bei dieser Betriebsart wird der pn-Übergang 22 des ersten Teilsegments 10 in Sperrrichtung geschaltet und damit eine Ladungsträgerrekombination in diesem Teilbereich unterdrückt. Bei einem gleichzeitigen Betrieb beider Teilsegmente werden an die erste Leitungsebene 405 über das Kontaktpad 40 sowie an die dritte Leitungsebene 425 über das hier nicht dargestellte Kontaktpad 42 eine Spannung angelegt, derart dass die beiden pn-Übergänge 22 und 22' der beiden Teilsegmente in Flussrichtung geschaltet werden. Ein Stromfluss erfolgt dann über die erste Leitungsebene 405 und dem Durchbruch 400 in den ersten pn-Übergang 22, von dort aus über die Zuführung 410 und die zweite Leitungsebene 415 in den zweiten Durchbruch 412 des zweiten Teilsegments 11. Die pn-Übergänge beider Teilsegmente sind dann in Flussrichtung geschaltet.

In Figur 2B ist eine Querschnittsansicht entlang der Achse II-II' gemäß der Ausführungsform nach Figur 1 dargestellt. Die beiden Teilsegmente 10 und 12 sind wiederum durch einen isolierenden Graben 20' getrennt, wodurch ein Stromfluss vermieden wird. Darüber hinaus reicht der mit einem Isolationsmaterial gefüllte Graben 20' bis in die zusätzliche Isolierungsschicht 502, der die einzelnen Leitungsebenen voneinander trennt. Die Teilsegmente 10 und 12 sind somit von einer isolierenden Schicht gebildet aus dem Graben 20' und den isolierenden Seitenbereichen 30 umgeben.

In der Figur 2B sind in der Schnittansicht lediglich die zweite Leitungsebene 415 und die dritte Leitungsebene 425 gezeigt. Die erste Leitungsebene 405, wie in der Querschnittsdarstellung nach Figur 2A zu erkennen, ist in der Schnittdarstellung nach Figur 2B nicht vorhanden, da die Leitungsebene 405 die Segmente 10 und 12 nicht direkt kontaktiert. Die n-dotierte Teilschicht 21' des Bereichs 10 beziehungsweise 21'' des Teilsegments 12 erfolgt durch mehrere Durchbrüche 412 beziehungsweise 412'' für beide Teilsegmente. Sie sind jeweils durch Gräben gebildet, an deren Seitenwänden ein Isolationsmaterial 413 abgeschieden ist. Dieses verhindert einen Kurzschluss und eine elektrische Kontaktierung mit den p-dotierten Teilschichten 23' des Teilsegments 10 beziehungsweise 23'' des Teilsegments 12. In der Kontaktebene 25', in der die Leitungsebenen verlaufen, sind die Durchbrüche zu einer gemeinsamen Leitungsebene 415 und 415'' zusammengeführt. Die p-dotierte Teilschicht 23 des Teilsegments 10 ist durch die Zuführungen 420 an die dritte Leitungsebene 425 angeschlossen. Entsprechend kontaktieren die Durchführungen 420'' die Teilschicht 23'' des Teilsegments 12 mit der dritten Leitungsebene 425''. Gemäß der Ausführungsform nach Figur 1 ist die dritte Leitungsebene 425'' des Teilsegments 12 an das Kontaktpad 44 und die zweite Leitungsebene 415'' des Teilsegments 12 an das Kontaktpad 43 geführt.

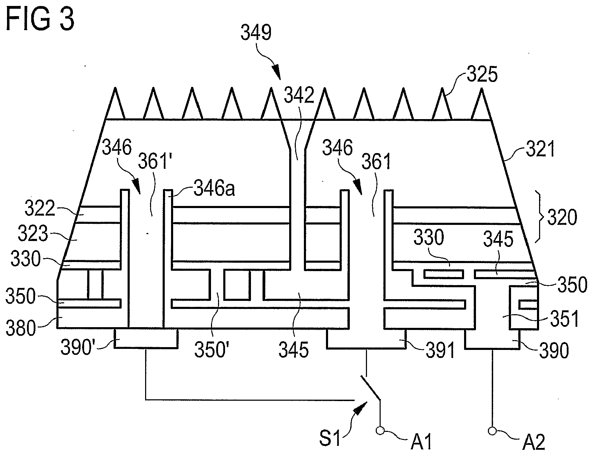

Figur 3 zeigt eine Querschnittsdarstellung einer weiteren Ausführungsform. Bei dieser sind ebenfalls alle Kontaktelemente rückseitig angeordnet. Die Halbleiterschichtenfolge 320 enthält wiederum eine erste n-dotierte Schicht 321, an die benachbart eine p-dotierte Schicht 323 aufgebracht ist. An der Grenzfläche bildet sich wie dargestellt ein pn-Übergang 322 aus.

Als Materialsystem der Schichtenfolge kann beispielsweise In-GaN/GaN verwendet werden, deren Emissionsspektrum im Bereich des sichtbaren blauen Lichtes liegt. Durch die vorgesehene aufgebrachte Strukturierung 325 wird eine Abstrahlungscharakteristik des optoelektronischen Halbleiterkörpers verbessert. Zudem kann darüber hinaus ein Konversionsmittel vorgesehen und auf der Oberfläche der Strukturierung 325 aufgebracht werden. Dadurch wird ein Teil des emittierten blauen Lichts in Licht einer anderen Wellenlänge konvertiert, wodurch sich die Erzeugung von weißem Licht realisieren lässt.

Auf der der Strukturierung 325 abgewandten Seite der zweiten Schicht 323 der Halbleiterschichtenfolge 320 ist eine leitende reflektierende Anschlussschicht 330 angeordnet. Diese dient gleichzeitig auch als laterale Stromaufweitungsschicht zur Einkopplung von Ladungsträgern. Die Schicht 330 wird durch mehrere Zuleitungselemente 350 kontaktiert, die ihrerseits mit einem Durchbruch 351 an ein rückseitig angeordnetes Kontaktpad 390 angeschlossen sind.

Weiterhin ist ein Durchbruch 346 vorgesehen, der mit einem elektrisch leitenden Material 361 gefüllt ist. Der Durchbruch 346 verläuft von der Rückseite des Halbleiterkörpers durch alle Schichten hindurch bis zur Schicht 321 der Halbleiterschichtenfolge 320. Seine Seitenwände sind im Wesentlichen mit einem isolierenden Material 364 fast vollständig umgeben, um einen Kurzschluss, beispielsweise mit der Anschlussschicht 330, zu vermeiden. Des Weiteren ist der Kontakt 361 mit einem Kontaktpad 391 auf der Rückseite des optoelektronischen Halbleiterkörpers sowie mit einer leitenden Materialschicht 350' verbunden. Die Materialschicht 350' kontaktiert die Anschlussschicht 330' des linken Teilsegments des Halbleiterkörpers. Selbiges ist vom rechten Teilsegment durch einen isolierenden Graben 342 elektrisch vollständig getrennt. Der Graben 342 ist mit einem Isolationsmaterial gefüllt, welches auch die Zwischenräume zwischen den einzelnen Durchführungen 350' und 350 auffüllt. Dieses isolierende Material kann gleichzeitig als Trägersubstrat für den Ersatzträger 380 verwendet werden.

Die leitende Schicht 350' bildet gemeinsam mit der Schicht 330' eine erste Anschlussschicht des linken Teilsegments des optoelektronischen Halbleiterkörpers und kontaktiert die Schicht 323 der Halbleiterschichtenfolge 320. Entsprechend ist auch im linken Teilbereich des Halbeiterkörpers ein Graben 361' ausgebildet, dessen Seitenwände 346a mit einem isolierenden Material versehen sind. Das Material des Grabens 361' kontaktiert das auf der rückseitigen Oberfläche befindlichen Kontaktpad 390'.

Extern sind die Kontaktpads 390' sowie 391 auf der Rückseite mit einem Schalter S1 gekoppelt, der an einen ersten Anschluss A1 führt. Der Kontakt 390 ist mit einem zweiten Anschluss A2 gekoppelt. In einem Betrieb der Anordnung wird nun abhängig von der Schalterstellung S1 werden nun lediglich der rechte Teil des optoelektronischen Bauelements oder beide Teile des optoelektronischen Bauelements mit Strom versorgt. In der dargestellten Schalterstellung fließt im Betrieb der Halbleiteranordnung ein Strom über den Kontakt 390 und die Zuführung 350 in die Halbleiterschichtenfolge des rechten Bereichs des Halbleiterkörpers. In dem dortigen pn-Übergang rekombinieren die Ladungsträger und emittieren Licht. Während des Betriebs ist in der dargestellten Schalterstellung der linke Teilbereich des Halbleiterkörpers abgeschaltet.

Wird nun der Anschluss A1 mit dem Kontaktpad 390' über den Schalter S1 gekoppelt, so fließt der Strom über den Graben 361' im rechten Teilbereich des Halbleiterkörpers in die erste Anschlussschicht aus den Schichten 350' und 330' im linken Teilbereich des Halbleiterkörpers. Dadurch sind die beiden Halbleiterschichtenfolge und ihre darin enthaltenen pn-Übergänge in Serie geschaltet.

Abhängig von der Ausgestaltung der einzelnen Anschlussschichten und ihrer Kontaktierung in den jeweiligen Teilsegmenten lässt sich so eine externe Parallel- oder Serienschaltung der einzelnen Teilsegmente eines optoelektronischen Halbleiterkörpers erreichen.

Die Verschaltung kann extern über eine integrierte Schaltung erfolgen. Diese steuert den Schalter an und umfasst zudem verschiedene Treiberstufen, um die einzelnen Segmente aber auch die Segmente in Serienschaltung mit der ausreichenden Spannung und Strom zu versorgen. Hierbei ist zu berücksichtigen, dass bei einer Serienschaltung die über die Segmente insgesamt abfallende Spannung entsprechend größer wird, während der dadurch fließende Strom im Wesentlichen gleich bleibt. Insofern ist also eine spannungsgetriebene Treiberstufe erforderlich. Ebenso kann der Strom durch die einzelnen Teilsegmente variiert werden, um unterschiedliche Lichtausbeute zu erreichen.

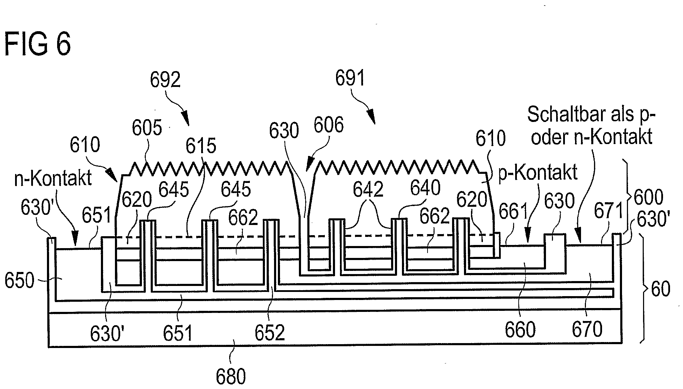

Figur 6 zeigt eine Querschnittsdarstellung einer weiteren Ausführungsform eines Halbleiterkörpers mit einer strukturierten Schichtenfolge 600, die auf einer Kontaktebene 601 angeordnet ist.

Die Schichtenfolge 600 ist an ihrer ersten Hauptseite mit einer Strukturierung 605 versehen und über einen Graben 606 und ein die Schichtenfolge durchtrennendes Isolationsmaterial 630 in zwei Teilsegmente aufgeteilt. Jedes Teilsegment umfasst somit eine Schichtenfolge aus einer n-dotierten ersten Teilschicht 610 sowie einer darunter angeordneten zweiten p-dotierten Teilschicht 620. Durch die unterschiedliche Dotierung bildet sich ein pn-Übergang 615 aus, der die aktive Schicht zur Erzeugung und Emission elektromagnetischer Strahlung darstellt.

Darunter angeordnet ist die Kontaktebene 601, die ihrerseits verschiedene Leitungsebenen aufweist. Diese kontaktieren die einzelnen Teilschichten 610 beziehungsweise 620 der beiden Teilsegmente. Dabei sind wie dargestellt Kontaktpads sowohl auf der rechten als auch auf der linken Seite der Halbleiterschichtenfolge 600 angeordnet. Im Einzelnen ist ein erster Kontakt 661 auf der der Hauptseite der zugewandten Seite benachbart zu dem ersten Teilbereich der Schichtenfolge ausgebildet. Dieses Kontaktpad 661, das in einem Betrieb den p-Kontakt der Anordnung bildet, steht in elektrisch leitender Verbindung zur ersten Leitungsebene 660.

Die Leitungsebene 660 kontaktiert die p-dotierte Teilschicht 620 des ersten Teilsegments 691 der Schichtenfolge. Dies erfolgt über eine unterhalb der p-dotierten Teilschicht 620 angeordnete elektrisch leitende Spiegelschicht 662. Die Spiegelschicht 662 unterhalb der p-dotierten Teilschicht 620 ist elektrisch leitend von der entsprechenden Spiegelschicht 662 des zweiten Teilsegments 692 durch das Isolationsmaterial 630 getrennt. Die Spiegelschicht 662 reflektiert ein im pn-Übergang 615 erzeugtes Licht in Richtung zur ersten Hauptseite und damit zur Strukturierung 605 hin.

Ein weiteres leitendes Kontaktpad 671 auf der Oberseite des Halbleiterkörpers ist über das Isolationsmaterial 630 von dem ersten Kontakt 661 getrennt und mit der zweiten Leitungsebene 670 verbunden. Das Material des zweiten Kontaktes 671 kann das gleiche Material wie die Leitungsebene 670 umfassen. Die Leitungsebene 670 kontaktiert die n-dotierte Teilschicht 610 des ersten Teilsegments 691 über eine Anzahl von Durchbrüchen 640. Diese Durchbrüche reichen durch die die erste Leitungsebene 660 von der zweiten Leitungsebene 670 trennende Isolationsschicht 630, die Leitungsebene 660, die Spiegelschicht 662, die p-dotierte Teilschicht 620 sowie den pn-Übergang in die Teilschicht 610 des ersten Teilsegments 691. Sie sind mit einem elektrisch leitenden Material gefüllt und die Außenwände 642 entsprechend isoliert. Dadurch wird ein Kurzschluss zwischen der zweiten Leitungsebene und der ersten Leitungsebene 660 beziehungsweise der Spiegelschicht oder der p-dotierten Teilschicht 620 vermieden.

Des Weiteren kontaktiert die zweite Leitungsebene 670 über die Spiegelschicht 662 auch die p-dotierte Teilschicht 620 des zweiten Teilsegments 692. Demzufolge steht die n-dotierte Teilschicht 610 des ersten Teilsegments 691 in elektrischem Kontakt mit der p-dotierten Teilschicht 620 des zweiten Teilsegments 692. Die pn-Übergänge 615 beider Teilsegmente 691 und 692 bilden somit eine Serienschaltung.

Schließlich ist benachbart zu dem zweiten Teilbereich 692 ein dritter Kontakt 651 vorgesehen. Dieser kontaktiert über die dritte Leitungsebene 650 und Gräben 645 die n-dotierte Teilschicht 610 des zweiten Teilsegments 692. Auch hier reichen die Durchbrüche 645 durch die zweite Leitungsebene 670, die Spiegelschicht 662, die p-dotierte Teilschicht 620 und dem pn-Übergang 615 in die n-dotierte Teilschicht 610 des zweiten Teilsegments. Isolierende Seitenwände 642 verhindern einen Kurzschluss zwischen der dritten Leitungsebene 650 und der zweiten Leitungsebene 670 beziehungsweise der Spiegelschicht 662. Schließlich ist die dritte Leitungsebene 651 durch eine Isolationsschicht 630' von einem Trägersubstrat 680 getrennt.

In einem Betrieb der Anordnung ist der Kontakt 671, verbunden mit der zweiten Leitungsebene 670 als schaltbarer Kontakt ausgeführt. Das bedeutet, dass je nach gewünschter Betriebsart entweder positive oder negative Ladungsträger zugeführt werden. Entsprechend schaltet er je nachdem, ob das erste Teilsegment oder das zweite Teilsegment angesteuert werden soll, den entsprechenden pn-Übergang in Fluss- beziehungsweise in Sperrrichtung. Wenn beispielsweise lediglich das erste Teilsegment 691 betrieben werden soll, wird das Kontaktpad 661 als p-Kontakt verwendet, der schaltbare Kontakt 671 als n-Kontakt.

Bei einem Betrieb lediglich des zweiten Teilsegments 692 wird das dritte Kontaktpad 651 als n-Kontakt betrieben, der schaltbare Kontakt 671 als p-Kontakt. In dieser Betriebsart wird dann der pn-Übergang 615 des ersten Teilsegments 691 in Sperrrichtung geschaltet. Bei einem Betrieb beider Teilsegmente in Form einer Serienschaltung werden die Kontaktpads 661 beziehungsweise 651 als p- beziehungsweise n-Kontakt verwendet. Der schaltbare Kontakt 671 wird in diesem Betriebsfall nicht angeschlossen.

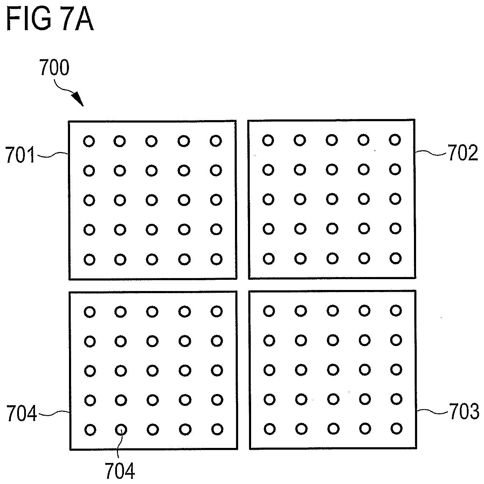

Die Figuren 7A bis 7I zeigen Draufsichten über einen monolithischen Halbleiterkörper in verschiedenen Stadien seiner Herstellung. Anhand dieser Ansichten soll der Herstellungsprozess insbesondere der Kontaktebene mit den verschiedenen Leitungsebenen und den dazwischen angeordneten isolierenden Materialien erläutert werden.

In Figur 71A ist die Draufsicht über die Halbleiterkörper 700 dargestellt, der vorliegend in vier Teilsegmente 701 bis 704 unterteilt ist. Zwischen jedem Teilsegment wird ein Graben definiert, um in späteren Prozessschritten die Halbleiterschichtenfolge jedes einzelnen Teilsegmentes 701 bis 704 voneinander elektrisch zu isolieren. Des Weiteren werden die für die n-dotierte Teilschicht vorgesehenen Löcher 701' in jedem Teilsegment definiert.

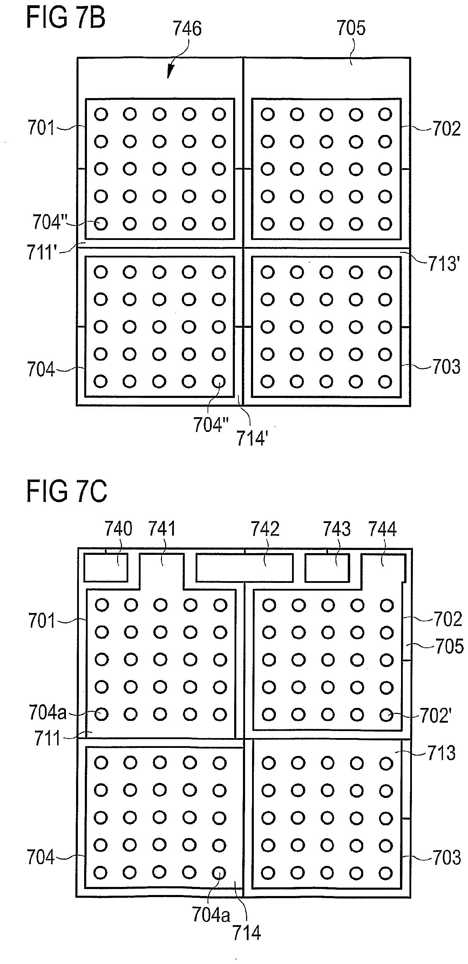

Anschließend wird gemäß Figur 7B die p-dotierte Teilschicht auf dem Halbleiterkörper und den Teilsegmenten 701 bis 704 aufgebracht, wobei in den Bereichen der späteren Durchbrüche zur n-dotierten Teilschicht hin Aussparungen 704'' vorgesehen sind. Des Weiteren ist ein Außenbereich 746 vorgesehen, auf dem die späteren Kontaktpads angeordnet sind.

Zwischen dem ersten Teilsegment 701 und dem vierten Teilsegment 704 ist ein weiterer Teilbereich 711' benachbart zu dem ersten Teilsegment 701 vorgesehen. Entsprechendes gilt für die Teilbereiche 713' zwischen dem zweiten Teilsegment 702 und dem dritten Teilsegment 703 sowie einen zu dem Teilsegment 704 benachbarten Teilbereich 714' zwischen dem Teilsegment 704 und dem Teilsegment 703.

Auf die p-dotierte Teilschicht wird gemäß Figur 7C nun eine Leitungsebene in jedem Teilsegment 701 bis 704 abgeschieden. Diese dient zur p-Kontaktverstärkung und koppelt gleichzeitig wie dargestellt einige der späteren Anschlusspads an die entsprechenden Segmente.

Im Einzelnen bildet ein Außenbereich der Kontaktverstärkung ein erstes Kontaktpanel 741, welches über die entsprechende Leitungsebene mit der p-dotierten Teilschicht des ersten Teilbereichs 701 verbunden ist. Wie zu erkennen, ist zudem der zwischen den Teilbereichen 701 und 704 des Halbleiterkörpers benachbarte Teilbereich 711' von der Leitungsebene bedeckt. Die Leitungsebene über dem Teilsegment 701 ist somit nicht mehr rechtecksförmig im Bereich des Segmentes 701 ausgebildet, sondern überdeckt das erste Teilsegment 701 und den zusätzlichen benachbarten Teilbereich 711.

In entsprechender Weise wird auch über dem vierten Teilsegment 704 eine Leitungsebene abgeschieden, die den zusätzlichen benachbarten Außenbereich 714' überlappt. Entsprechend wird in diesem Bereich ein zusätzlicher Teilbereich 714 gebildet. Gleiches gilt für den zusätzlich definierten Teilbereich 713, der mit der Leitungsebene über der p-dotierten Teilschicht des Segmentes 703 liegt.

Schließlich ist eine letzte p-Kontaktverstärkung und Leitungsebene über dem Teilsegment 702 angeordnet. Diese Kontaktverstärkung 702' steht zudem in elektrisch leitendem Kontakt mit dem Kontaktpanel 744, der dadurch die p-dotierte Teilschicht des Segmentes 702 kontaktiert. Weiterhin sind drei zusätzliche Kontaktbereiche 740, 742 und 743 definiert und mit einer Metallisierung versehen. Zwischen den einzelnen Kontaktbereichen 740 bis 743 sind isolierende Zwischenbereiche angeordnet. Weiterhin enthielt jede p-Kontakt verstärkende Leitungsebene in den einzelnen Segmenten Aussparungen 704a im Bereich der späteren Durchbrüche.

Anschließend wird eine Isolationsschicht auf der Schichtenfolge und den ersten Leitungsebenen der einzelnen Segmente aufgebracht.

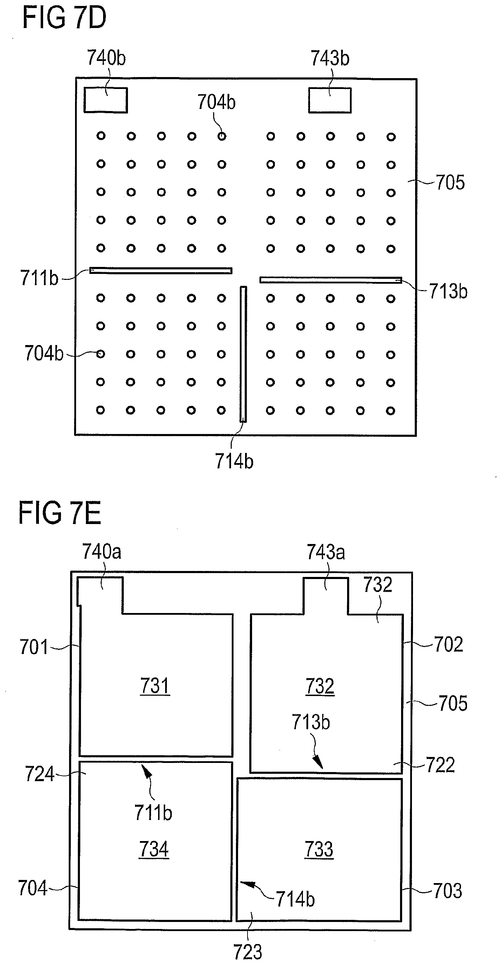

Figur 7D zeigt den nächsten Arbeitsschritt, in der das isolierende Material im Bereich der Durchbrüche geöffnet wird. Die daraus sich ergebenden Durchbrüche 704b ermöglichen die spätere Kontaktierung der n-dotierten Teilschicht der jeweiligen Segmente. Des Weiteren werden die Teilbereiche über den vorher definierten Kontaktbereichen geöffnet und die darunter liegende Metallisierung zur Bildung der Kontaktflächen 740b und 743b freigelegt. Ebenso wird ein schmaler Grad 711b, 714b und 713b aus dem isolierenden Material geätzt und die darunter liegenden Teilbereiche 711, 714 und 713 freigelegt.

In Figur 7E ist schließlich der Halbleiterkörper nach dem Aufbringen der zweiten Leitungsebene gezeigt. Dies kann durch Abscheiden einer Metallisierung auf der Schichtenfolge und anschließende Strukturierung erfolgen. Es wird so auf jedem Teilsegment 701 bis 704 eine entsprechende leitende Schicht 731, 732, 733 und 734 aufgebracht. Im Einzelnen ist die Leitungsebene 731 des ersten Teilsegments 701 zudem im Bereich 740a herausgeführt, sodass sie die Kontaktmetallisierung im darunter liegenden Bereich 740b kontaktiert. Des Weiteren ist die Leitungsebene 734 über dem vierten Teilsegment 704 in einem Teilbereich 724 über das Teilsegment 704 hinaus gewachsen, sodass sie den darunter liegenden und in der vorhergehenden Figur dargestellten Durchbruch 711b überlappt und somit die in dem Graben 711b freigelegte p-Kontaktierungsschicht kontaktiert.

In gleicher Weise ist auch die Leitungsebene 733 über dem dritten Teilsegment 703 in einem Teilbereich 723 über den darunter liegenden Graben 714b aufgewachsen. Entsprechend überlappt die Leitungsebene 732 über dem Teilsegment 702 den Durchbruch 713b im Teilbereich 722 und kontaktiert darüber hinaus im Bereich 743a die darunter liegende Kontaktmetallisierung 743b.

Somit wird die n-Kontaktverdrahtung definiert und gleichzeitig auf die entsprechenden Kontaktpads herausgeführt. Mit anderen Worten kontaktiert die Leitungsebene 732 einerseits die n-dotierte Teilschicht des Teilsegmentes 702 und gleichzeitig über den Graben 713b die p-dotierte Teilschicht des Teilsegmentes 703. Entsprechend kontaktiert die Leitungsebene 733 des Teilsegments 703 die n-dotierte Teilschicht des Teilsegmentes 703 durch die in den vorhergehenden Figuren dargestellten Durchbrüche und zudem über den Graben 714b die p-dotierte Teilschicht des Teilsegmentes 704. Die Leitungsebene 734 des Teilsegmentes 704 kontaktiert die n-dotierte Teilschicht des Segmentes 704 über die entsprechenden Durchbrüche und über den Graben 711b die p-dotierte Teilschicht des Teilsegmentes 701.

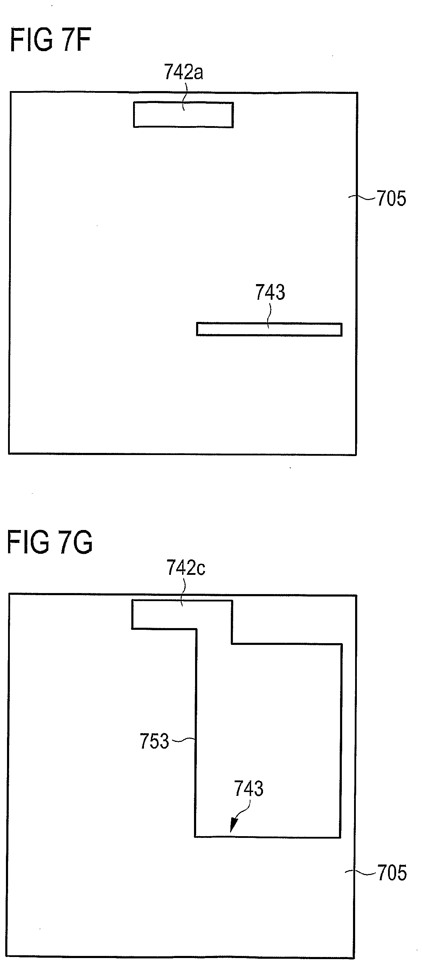

In Figur 7F wird schließlich das zentrale Kontaktpad 742a sowie die separate dritte Leitungsebene 743 definiert. Dazu wird auf die in den vorangegangenen Prozessschritten hergestellten Leitungsebenen 731 bis 734 der Teilsegmente 701 bis 704 eine Isolationsschicht aufgewachsen. Zweckmäßigerweise wird die Isolationsschicht auf der gesamten Fläche des Halbleiterkörpers gewachsen, um auch eventuell vorhandene Stufen auszugleichen. In der gewachsenen Isolationsschicht wird im Bereich 742a das zentrale Kontaktpad und im Bereich 743 ein entsprechender Durchbruch definiert. Anschließend wird das Isolationsmaterial in diesen Bereichen entfernt, sodass einerseits im Bereich 742a die darunter liegende Metallisierungsschicht des Kontaktpads 742 freigelegt wird. Im Bereich 743 wird ein Durchbruch durch die Isolationsschicht gebildet, der die darunter liegende Leitungsebene 733 des dritten Segmentes 703 freilegt.

Gemäß Figur 7G wird nun auf die Isolationsschicht über eine weitere Leitungsebene 753 der Kontaktbereich 742c mit der zweiten Leitungsebene 733 des dritten Teilsegments 703 über den Durchbruch 743 kontaktiert. Wie hier dargestellt, ist die dritte Leitungsebene 753 flächig als Metallisierung aufgebracht. Dies ist insbesondere dann zweckmäßig, wenn Stufen aufgrund der verschiedenen Verdrahtungslagen während des Aufwachsens vermieden werden sollen. Alternativ kann die dritte Leitungsebene 753 auch als einfache Zuleitung ausgeführt sein.

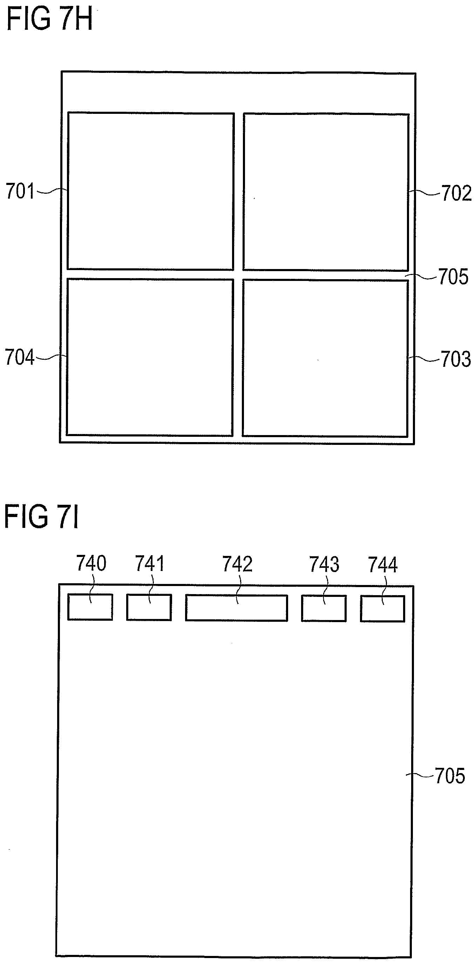

Anschließend wird die Schichtenfolge des Halbleiterkörpers und die dritte Leitungsebene flächig von einer isolierenden Schicht bedeckt, um eine gleichmäßige Rückseite zu bilden und eventuell vorhandene Stufen zu kompensieren. Sodann wird gemäß Figur 7H das vorhandene Aufwachssubstrat durch einen so genannten Laser Lift-off-Prozess entfernt. Dieser erfolgt durch Einstrahlung eines Lasers, bei dem das Aufwachssubstrat von der bislang gefertigten Schichtenfolge entfernt wird. Die Schichtenfolge wird nun mit ihrer Rückseite auf ein Trägersubstrat aufgebracht, so dass die in der Figur 7G gebildete Leitungsebene dem Trägersubstrat benachbart ist. Auch kann ein nasschemisches Verfahren zur Entfernung des Aufwachssubstrats verwendet werden.

Figur 7H zeigt nun die Draufsicht auf die erste Hauptseite der gewachsenen Schichtenfolge, in die später Betrieb die Emission der elektromagnetischen Strahlung erfolgen soll. In einem weiteren Schritt werden die in Figur 7A definierten Zwischenbereiche als Graben geätzt, sodass die einzelnen Teilsegmente 701 bis 704 des Halbleiterkörpers 705 elektrisch voneinander isoliert werden. Die Grabentiefe geht somit zumindest durch die beiden n- und p-dotierten Teilschichten sowie die aktive Schicht der Schichtenfolge. Die Kontaktebene mit den einzelnen Leitungsbahnen wird hingegen von dem Graben nicht durchtrennt, da andernfalls die in den vorangegangenen Prozessschritten hergestellte Serienschaltung der einzelnen Segmente unterbrochen ist.

Im letzten Prozessschritt gemäß Figur 7I werden nun von der Vorderseite die Kontaktpads 740 bis 744 des Halbleiterkörpers 705 freigelegt.

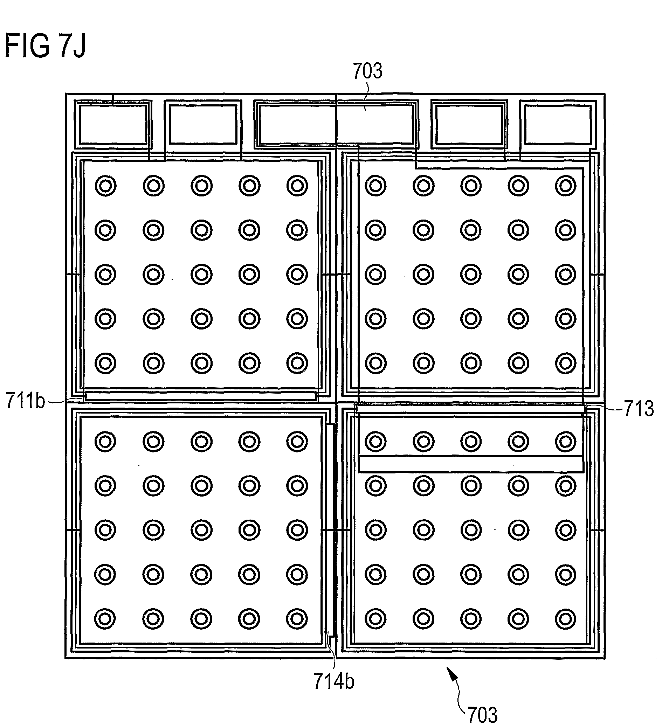

Die Figur 7J zeigt schließlich in schematischer Darstellung eine Gesamtübersicht über die einzelnen Lithografieschritte. Deutlich zu erkennen sind die verschiedenen Kontaktebenen, insbesondere die Kontaktebene des zentralen Kontaktpanels 742, welche das Teilsegment 703 mit dem Kontaktpanel 742 verbindet. Durch die entsprechenden Teilbereiche der Segmente 703, 704 und 701 wird eine Serienschaltung aus allen vier Segmenten realisiert, und dadurch ein spannungsgetriebenes Licht emittierendes Halbleiterbauelement implementiert. Durch die Verdrahtung auf der der Emission gegenüberliegenden Seite wird eine Abschattung der Oberseite verhindert und die Lichtausbeute maximiert. Gleichzeitig können durch die selektive Ansteuerung einzelne Teilsegmente des Halbleiterkörpers betrieben werden.

Die hier dargestellte Ausführungsform ist nicht auf eine 2 • 2-Matrix beschränkt. Vielmehr lassen sich eine beliebige Anzahl von einzelnen Teilsegmenten eines Halbleiterkörpers unter Bildung einer Serien- beziehungsweise Parallelschaltung miteinander kombinieren. Verschiedene Leitungsebenen in einer der Emissionsseite abgewandten Kontaktebene erlaubt eine je nach Anwendungsfall geeignete Verschaltung der einzelnen Teilsegmente. Die Möglichkeit, Segmente in Serie zu koppeln, verringert den Stromfluss durch die einzelnen Teilsegmente des Halbleiterkörpers, sodass einfache Treiberbausteine verwendet werden können.

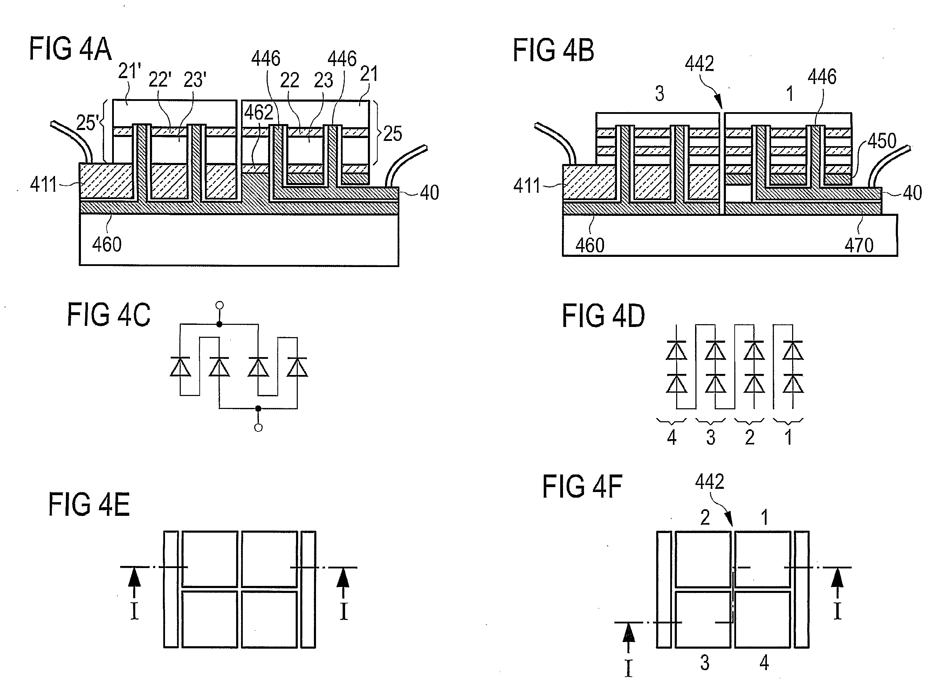

Je nach gewünschter Verschaltung lassen sich so verschiedene Ausführungsformen in einer Matrix aus einzelnen im Betrieb elektromagnetische Strahlung erzeugende Teilsegmente eines optoelektronischen Halbleiterkörpers realisieren. Dabei können die einzelnen Teilsegmente als gemeinsame Schichtenfolge gefertigt werden. Nach der Fertigung werden sie durch isolierende Graben in Teilsegmente getrennt. Durch das Aufbringen auf der Hauptseite abgewandten Kontaktebene mit den einzelnen Leitungsebenen lässt sich eine beliebige Verschaltung der einzelnen Teilsegmente erzielen. Diesbezüglich zeigen die Figuren 4A bis 4F eine schematische Darstellung einer weiteren Ausführungsform nach dem vorgeschlagenen Prinzip.

Figur 4A ist eine Schnittdarstellung durch einen optoelektronischen Halbleiterkörper entlang der in Figur 4E gezeigten Richtung. Eine Kontaktierung erfolgt jeweils im Randbereich durch die Kontaktelemente 40 beziehungsweise 411. Das Kontaktelement 40 ist mit den Durchbrüchen 446 elektrisch leitend verbunden, welche die Teilschicht 21 der Halbleiterschichtenfolge 20 kontaktieren. Zwischen den beiden unterschiedlich dotierten Teilschichten 21 und 23 bildet sich ein pn-Übergang 22 aus, in der die im Betrieb injizierten Ladungsträger rekombinieren und elektromagnetische Strahlung emittieren. Auf der Schicht 23 ist zudem eine laterale Stromverteilungsschicht 462 angeordnet, die das gleiche Material wie die Kontaktschicht 411 aufweist des zweiten Teilsegments des Halbleiterkörpers.

Eine zweite Anschlussschicht 460 kontaktiert die Stromverteilungsschicht 462 des rechten Teilsegments des optoelektronischen Halbleiterkörpers und bildet die Durchbruchskontaktierung für die Schicht 21' der Halbleiterschichtenfolge im linken Teilsegment des optoelektronischen Halbleiterkörpers. Entsprechend ist die zweite Anschlussschicht 410 mit der zweiten Schicht 23' der Halbleiterschichtenfolge 20' verbunden.

Zwischen dem linken und dem rechten Teilsegment des optoelektronischen Halbleiterkörpers ist wie in der Schnittfigur 4A sowie in der Draufsicht der Figur 4E dargestellt ein isolierender Graben vorgesehen. Dadurch werden die Teilsegmente elektrisch voneinander getrennt. Im Ersatzschaltbild gemäß Figur 4C sind somit jeweils zwei Dioden in Serie geschaltet. Die Diodenwirkung ergibt sich dabei aus dem dargestellten pn-Übergang der Halbleiterschichtenfolge 20 beziehungsweise 20'.

Figur 4B zeigt eine alternative Ausgestaltung, bei der anstelle eines einfachen pn-Übergangs mehrere pn-Übergänge vorgesehen sind. Diese Übergänge wirken wie zwei hintereinander geschaltete Dioden, wie sich aus dem Ersatzschaltbild nach Figur 4D ergibt.

Die Darstellung des Schnitts gemäß Figur 4B erfolgt entlang der Achsen I wie in Figur 4F gezeigt. In diesem Ausführungsbeispiel ist der optoelektronische Halbleiterkörper in vier Teilsegmente unterteilt, die jeweils von einem Graben 442 isolierend getrennt sind. Die verschiedenen Anschlussschichten 40, 411, 460 und 450 kontaktieren jeweils die Halbleiterschichtenfolgen der verschiedenen Teilsegmente und die darin befindlichen pn-Übergänge. Die Anschlussschichten 40, 411, 450 bis 470 sind dabei derart ausgestaltet, dass sie die vier Teilsegmente wie in dem Ersatzschaltbild gemäß Figur 4D erläutert verschalten.

Dadurch wird bei dem optoelektronischen Halbleiterkörper nach dem vorgeschlagenen Prinzip eine Serienschaltung aus vier jeweils zwei hintereinander geschalteten Dioden realisiert. Im Betrieb der Anordnung wird demzufolge eine höhere Betriebsspannung notwendig. Durch die elegante Kombination aus Serienschaltungen in der Epitaxieschicht können teure Treiberstufen und Hochstromquellen eingesetzt werden, da die Leistungen nunmehr spannungsgetrieben bei niedrigen Strömen in den optoelektronischen Halbleiterkörper gespeist wird. Zudem ergibt sich eine optimierte Flächennutzung durch Vermeidung von absorbierenden Kontakten, da alle lichterzeugenden Bestandteile stromsparend auf einem einzelnen Halbleiterkörper realisierbar sind. Zudem lässt sich eine Serienschaltung von Chips auch nur mit nur einem Topkontakt und einem leitenden Träger ausführen.

## Patentansprüche

1. Monolithischer, optoelektronischer Halbleiterkörper, umfassend:
- eine Halbleiterschichtenfolge (25), die in wenigstens zwei elektrisch voneinander isolierte Teilsegmente (10-13) unterteilt ist und eine erste und eine zweite Hauptseite aufweist, wobei die Halbleiterschichtenfolge in jedem Teilbereich eine zur Erzeugung elektromagnetischer Strahlung geeignete aktive Schicht (22) aufweist;
- und bei der die erste Hauptseite der Halbleiterschichtenfolge zu Emission von in der aktiven Schicht erzeugter elektromagnetischer Strahlung vorgesehen ist;
- ein erstes Kontaktpad (40), ein zweites Kontaktpad (41) und zumindest ein drittes Kontaktpad (42),
- eine erste, der zweiten Hauptseite benachbart angeordnete Leitungsebene (405), welche ein erstes der wenigstens zwei Teilsegmente und das erste Kontaktpad elektrisch kontaktiert,
- eine zweite, der zweiten Hauptseite benachbart angeordnete Leitungsebene (415), welche ein zweites der wenigstens zwei Teilsegmente und das zweite Kontaktpad elektrisch kontaktiert,
- eine dritte, der zweiten Hauptseite benachbart angeordnete Leitungsebene (425), welche das erste und das zweite Teilsegment elektrisch zur Erzeugung elektromagnetischer Strahlung miteinander verbindet, so dass die aktiven Schichten des ersten und zweiten Teilsegments eine Serienschaltung bilden, und das dritte Kontaktpad elektrisch kontaktiert,
wobei wenigstens eine der ersten, zweiten und dritten Leitungsebene und eine andere der ersten, zweiten und dritten Leitungsebene überlappen und durch eine Isolationsschicht (501-503) getrennt sind und wobei auf der zweiten Hauptseite ein Trägersubstrat angeordnet ist und die erste, zweite und dritte Leitungsebene zumindest teilweise zwischen einem Trägersubstrat und der Halbleiterschichtenfolge angeordnet sind.

2. Monolithischer, optoelektronischer Halbleiterkörper nach Patentanspruch 1, bei dem
das erste Teilsegment eine erste Teilschicht und eine durch die aktive Schicht getrennte zweite Teilschicht umfasst,
bei dem das zweite der wenigstens zwei Teilsegmente eine erste Teilschicht und eine durch die aktive Schicht getrennte zweite Teilschicht aufweist und
bei dem die dritte Leitungsebene die erste Teilschicht des ersten Teilsegments und die zweite Teilschicht des zweiten Teilsegments kontaktiert.

3. Monolithischer, optoelektronischer Halbleiterkörper nach Anspruch 2, bei dem wenigstens eines der Teilsegmente einen Durchbruch aufweist, welcher durch die aktive Schicht des Teilsegments verläuft und die der ersten Hauptseite zugewandte Teilschicht des Teilsegments kontaktiert.

4. Monolithischer, optoelektronischer Halbleiterkörper nach einem der Ansprüche 1 bis 3, bei dem wenigstens ein Kontaktpad des ersten, zweiten und dritten Kontaktpads auf der der ersten Hauptseite abgewandten Seite der Halbleiterschichtenfolge angeordnet ist.

5. Monolithischer, optoelektronischer Halbleiterkörper nach einem der Ansprüche 1 bis 4, weiter umfassend
- einen von den wenigstens zwei Teilsegmenten elektrisch isolierten Außenbereich, der benachbart zu zumindest einem der wenigstens zwei Teilsegmente angeordnet ist und auf einer der ersten Hauptseite zugewandten Seite wenigstens ein Kontaktpad des ersten, zweiten und dritten Kontaktpads aufweist.

6. Monolithischer, optoelektronischer Halbleiterkörper nach einem der Ansprüche 1 bis 5, bei dem wenigstens eine der ersten, zweiten und dritten Leitungsebene eine Spiegelschicht umfasst, die eine in der aktiven Schicht erzeugte elektromagnetische Strahlung in Richtung zur ersten Hauptseite reflektiert.

7. Monolithischer, optoelektronischer Halbleiterkörper nach einem der Ansprüche 1 bis 6, bei dem zwischen der Schichtenfolge und wenigstens einer der ersten, zweiten und dritten Leitungsebene eine Spiegelschicht angeordnet ist zur Reflektion von in der aktiven Schicht erzeugten elektromagnetische Strahlung in Richtung zur ersten Hauptseite.

8. Monolithischer, optoelektronischer Halbleiterkörper nach Anspruch 7, bei dem die Spiegelschicht elektrisch isoliert von der aktiven Schicht des ersten und/oder wenigstens einen zweiten Teilsegments ist und von der wenigstens einen Leitungsebene ist.

9. Monolithischer, optoelektronischer Halbleiterkörper nach einem der Ansprüche 7 bis 8, bei dem die Spiegelschicht eine Mehrzahl von Öffnungen aufweist und die wenigstens eine Leitungsebene durch die Öffnungen verlaufen.

10. Monolithischer, optoelektronischer Halbleiterkörper nach einem der Ansprüche 6 oder 9, bei dem die Spiegelschicht 50 % oder mehr der zweiten Hauptseite der Halbleiterschichtenfolge bedeckt.

11. Verfahren zur Herstellung eines monolithischen, optoelektronischen Halbleiterkörpers, umfassend:
- Epitaktisches Aufwachsen einer Halbleiterschichtenfolge (25) auf einem Aufwachssubstrat, wobei die Halbleiterschichtenfolge eine zur Erzeugung von elektromagnetischer Strahlung geeignete aktive Schicht (22) aufweist;
- Definieren eines ersten Teilsegments und (10-13) wenigstens eines hiervon elektrisch isolierten zweiten Teilsegments der Halbleiterschichtenfolge, die zu einer Emission elektromagnetischer Strahlung in Richtung auf eine erste Hauptseite vorgesehen sind;
- Ausbilden einer ersten Leitungsebene (405) an einer der ersten Hauptseite abgewandten Seite der Halbleiterschichtenfolge und Kontaktieren der aktiven Schicht des ersten Teilsegments;
- Ausbilden einer zweiten Leitungsebene (415) an der der ersten Hauptseite abgewandten Seite der Halbleiterschichtenfolge und Kontaktieren der aktiven Schicht des wenigstens einen zweiten Teilsegments;
- Ausbilden wenigstens einer dritten Leitungsebene (425) an der der ersten Hauptseite abgewandten Seite der Halbleiterschichtenfolge und Kontaktieren der aktive Schicht des ersten Teilsegments und der aktiven Schicht des wenigstens einen zweiten Teilsegments, wobei die dritte Leitungsebene die aktive Schichten der wenigstens zwei Teilsegmente unter Bildung einer Serienschaltung miteinander koppelt;
- Anordnen eines Trägersubstrats auf der der ersten Hauptseite abgewandten Seite der Halbleiterschichtenfolge, wobei die erste, zweite und dritte Leitungsebene zumindest teilweise zwischen einem Trägersubstrat und der Halbleiterschichtenfolge angeordnet sind;
- Ausbilden eines ersten Kontaktpads (40), das mit der ersten Leitungsebene verbunden ist;
- Ausbilden eines zweiten Kontaktpads (41), das mit der zweiten Leitungsebene verbunden ist;
- Ausbilden wenigstens eines dritten Kontaktpads (42), das mit der zumindest einen dritten Leitungsebene verbunden ist, wobei wenigstens eine der ersten, zweiten und dritten Leitungsebene und eine andere der ersten, zweiten und dritten Leitungsebene überlappen und durch eine Isolationsschicht (501-503) getrennt sind.

12. Verfahren nach Anspruch 11, bei dem ein Epitaktisches Aufwachsen umfasst:
- ein Aufbringen einer Spiegelschicht auf einer der ersten Hauptseite abgewandten Seite der Halbleiterschichtenfolge.

13. Verfahren nach einem der Ansprüche 11 bis 12, bei dem das Epitaktische Aufwachsen umfasst:
- Bereitstellen eines Aufwachsubstrats;
- epitaktisches Aufwachsen einer ersten Teilschicht mit einem ersten Dotiertyp;
- epitaktisches Aufwachsen einer zweiten Teilschicht mit einem zweiten Dotiertyp auf der ersten Teilschicht, so dass sich zwischen der ersten und der zweiten Teilschicht die aktive Schicht ausbildet.

14. Verfahren nach einem der Ansprüche 11 bis 13, bei dem das Ausbilden wenigstens einer der ersten, zweiten und zumindest einen dritten Leitungsebene ein Aufbringen eines isolierenden Materials und anschließendes Strukturieren des aufgebrachten isolierenden Materials umfasst.

## Claims

1. A monolithic, optoelectronic semiconductor body, comprising:
- a semiconductor layer sequence (25) which is subdivided into at least two subsegments (10-13) which are electrically isolated from one another and which semiconductor layer sequence has a first and a second main face, wherein the semiconductor layer sequence in each subarea has an active layer (22) which is suitable for producing electromagnetic radiation;
- and in which the first main face of the semiconductor layer sequence is intended to emit electromagnetic radiation produced in the active layer;
- a first contact pad (40), a second contact pad (41) and at least one third contact pad (42),
- a first line level (405), which is arranged adjacent to the second main face and makes electrical contact with a first of the at least two subsegments and with the first contact pad,
- a second line level (415), which is arranged adjacent to the second main face and makes electrical contact with a second of the at least two subsegments and with the second contact pad,
- a third line level (425), which is arranged adjacent to the second main face, electrically connects the first and the second subsegments to one another to produce electromagnetic radiation, so that the active layers of the first and the second subsegments form a series circuit, and makes electrical contact with the third contact pad,
wherein at least one of the first, second and third line levels and another of the first, second and third line levels overlap and are isolated from one another by an insulation layer (501-503) and
wherein, on the second main face, a mount substrate is arranged and the the first, second and third line levels at least partially are arragned between a mount substrate and the semiconductor layer sequence.

2. The monolithic, optoelectronic semiconductor body as claimed in patent claim 1, in which
the first subsegment comprises a first sublayer and a second sublayer, which is separated by the active layer, in which the second of the at least two subsegments has a first sublayer and a second sublayer which is separated by the active layer, and
in which the third line level makes contact with the first sublayer of the first subsegment and with the second sublayer of the second subsegment.

3. The monolithic, optoelectronic semiconductor body as claimed in claim 2, in which at least one of the subsegments has an aperture, which runs through the active layer of the subsegment and makes contact with that sublayer of the subsegment which faces the first main face.

4. The monolithic, optoelectronic semiconductor body as claimed in one of claims 1 to 3, in which at least one contact pad of the first, second and third contact pads is arranged on that face of the semiconductor layer sequence which faces away from the first main face.

5. The monolithic, optoelectronic semiconductor body as claimed in one of claims 1 to 4, furthermore comprising
- an outer area, which is electrically isolated from the at least two subsegments, is arranged adjacent to at least one of the at least two subsegments and has at least one contact pad of the first, second and third contact pads on a face which faces the first main face.

6. The monolithic, optoelectronic semiconductor body as claimed in one of claims 1 to 5, in which at least one of the first, second and third line levels comprises a mirror layer which reflects electromagnetic radiation produced in the active layer in the direction of the first main face.

7. The monolithic, optoelectronic semiconductor body as claimed in one of claims 1 to 6, in which a mirror layer is arranged between the layer sequence and at least one of the first, second and third line levels, in order to reflect electromagnetic radiation produced in the active layer in the direction of the first main face.

8. The monolithic, optoelectronic semiconductor body as claimed in claim 7, in which the mirror layer is electrically isolated from the active layer of the first and/or at least one second subsegment, and from the at least one line level.

9. The monolithic, optoelectronic semiconductor body as claimed in one of claims 7 or 8, in which the mirror layer has a plurality of openings, and the at least one line level runs or run through the openings.

10. The monolithic, optoelectronic semiconductor body as claimed in one of claims 6 or 9, in which the mirror layer covers 50% or more of the second main face of the semiconductor layer sequence.

11. A method for producing a monolithic, optoelectronic semiconductor body, comprising:
- epitaxial growth of a semiconductor layer sequence (25) on a growth substrate, wherein the semiconductor layer sequence has an active layer (22) which is suitable for producing electromagnetic radiation;
- definition of a first subsegment (10-13) and of at least one second subsegment, which is electrically isolated therefrom, of the semiconductor layer sequence, which are intended to emit electromagnetic radiation in the direction of a first main face;
- formation of a first line level (405) on a face of the semiconductor layer sequence which faces away from the first main face, and making contact with the active layer of the first subsegment;
- formation of a second line level (415) on the face of the semiconductor layer sequence which faces away from the first main face, and making contact with the active layer of the at least one second subsegment;
- formation of at least one third line level (425) on the face of the semiconductor layer sequence which faces away from the first main face, and making contact with the active layer of the first subsegment and with the active layer of the at least one second subsegment, wherein the third line level couples the active layers of the at least two subsegments to one another, forming a series circuit;
- arranging a mount substrate on the face of the semiconductor layer sequence which faces away from the first main face, wherein the the first, second and third line levels at least partially are arragned between a mount substrate and the semiconductor layer sequence;
- formation of a first contact pad (40) which is connected to the first line level;
- formation of a second contact pad (41) which is connected to the second line level;
- formation of at least one third contact pad (42) which is connected to the at least one third line level, wherein at least one of the first, second and third line levels and another of the first, second and third line levels overlap and are isolated from one another by an insulation layer (501-503).

12. The method as claimed in claim 11, in which epitaxial growth comprises:
- application of a mirror layer to a face of the semiconductor layer sequence which faces away from the first main face.

13. The method as claimed in one of claims 11 or 12, in which the epitaxial growth comprises:
- provision of a growth substrate;
- epitaxial growth of a first sublayer of a first dopant type;
- epitaxial growth of a second sublayer of a second dopant type on the first sublayer, such that the active layer is formed between the first and the second sublayers.

14. The method as claimed in one of claims 11 to 13, in which the formation of at least one of the first, second and at least one third line levels comprises application of an insulating material and subsequent structuring of the applied insulating material.

## Revendications

1. Corps semi-conducteur optoélectronique monolithique, comprenant :
- une succession de couches semi-conductrices (25), qui est divisée en au moins deux segments partiels (10 - 13) électriquement isolés les uns des autres et qui présente une première et une deuxième côtés principal,
la succession de couches semi-conductrices présentant dans chaque zone partielle une couche active (22) apte à générer un rayonnement électromagnétique ;
- et dans laquelle le premier côté principal de la succession de couches semi-conductrices est prévu pour émettre un rayonnement électromagnétique généré dans la couche active ;
- un premier plot de contact (40), un deuxième plot de contact (41) et au moins un troisième plot de contact (42),
- un premier plan conducteur (405) disposé de manière adjacente au deuxième côté principal, lequel plan conducteur met en contact électrique un premier des au moins deux segments partiels et le premier plot de contact,
- un deuxième plan conducteur (415) disposé de manière adjacente au deuxième côté principal, lequel plan conducteur met en contact électrique un deuxième des au moins deux segments partiels et le deuxième plot de contact,
- un troisième plan conducteur (425) disposé de manière adjacente au deuxième côté principal, lequel plan conducteur relie entre eux le premier et le deuxième segments partiels de manière électrique pour générer le rayonnement électromagnétique, de sorte que les couches actives du premier et du deuxième segments partiels forment un circuit en série, et lequel plan met en contact électrique le troisième plot de contact,
au moins un du premier, du deuxième et du troisième plans conducteurs et un autre plan conducteur du premier, du deuxième et du troisième plans conducteur se chevauchant et étant séparés par une couche d'isolation (501 - 503), et
un substrat de support étant disposé sur le deuxième côté principal, et le premier, le deuxième et le troisième plans conducteurs étant disposés au moins en partie entre un substrat de support et la succession de couches semi-conductrices.

2. Corps semi-conducteur optoélectronique monolithique selon la revendication 1, dans lequel
le premier segment partiel comprend une première couche partielle et une deuxième couche partielle séparée par la couche active,
dans lequel le deuxième des au moins deux segments partiels présente une première couche partielle et une deuxième couche partielle séparée par la couche active, et
dans lequel le troisième plan conducteur met en contact la première couche partielle du premier segment partiel et la deuxième couche partielle du deuxième segment partiel.

3. Corps semi-conducteur optoélectronique monolithique selon la revendication 2, dans lequel au moins un des segments partiels présente un passage qui s'étend à travers la couche active du segment partiel et met en contact la couche partielle du segment partiel, tournée vers le premier côté principal.

4. Corps semi-conducteur optoélectronique monolithique selon l'une quelconque des revendications 1 à 3, dans lequel au moins un plot de contact du premier, du deuxième et du troisième plots de contact est disposé sur le côté de la succession de couches semi-conductrices, détourné du premier côté principal.

5. Corps semi-conducteur optoélectronique monolithique selon l'une quelconque des revendications 1 à 4, comprenant en outre
- une zone extérieure électriquement isolée des au moins deux segments partiels, laquelle est disposée de manière avoisinante à au moins un des au moins deux segments partiels et présente sur un côté tourné vers le côté principal au moins un plot de contact du premier, du deuxième et du troisième plots de contact.

6. Corps semi-conducteur optoélectronique monolithique selon l'une quelconque des revendications 1 à 5, dans lequel au moins un du premier, du deuxième et du troisième plans conducteurs comprend une couche réfléchissante qui réfléchit en direction du premier côté principal un rayonnement électromagnétique généré dans la couche active.

7. Corps semi-conducteur optoélectronique monolithique selon l'une quelconque des revendications 1 à 6, dans lequel entre la succession de couches et au moins un du premier, du deuxième et du troisième plans conducteurs est disposée une couche réfléchissante pour la réflexion en direction du premier côté principal du rayonnement électromagnétique généré dans la couche active.

8. Corps semi-conducteur optoélectronique monolithique selon la revendication 7, dans lequel la couche réfléchissante est électriquement isolée de la couche active du premier et/ou de l'au moins un deuxième segment partiel et de l'au moins un plan conducteur.

9. Corps semi-conducteur optoélectronique monolithique selon l'une quelconque des revendications 7 à 8, dans lequel la couche réfléchissante présente une pluralité d'ouvertures et dans lequel l'au moins un plan conducteur s'étend à travers des ouvertures.

10. Corps semi-conducteur optoélectronique monolithique selon l'une quelconque des revendications 6 à 9, dans lequel la couche réfléchissante recouvre 50% ou plus du deuxième côté principal de la succession de couches semi-conductrices.

11. Procédé de fabrication d'un corps semi-conducteur optoélectronique monolithique, comprenant :
- croissance épitaxiale d'une succession de couches semi-conductrices (25) sur un substrat de croissance, la succession de couches semi-conductrices présentant une couche active (22) apte à générer un rayonnement électromagnétique ;
- définition d'un premier segment partiel (10 - 13) et d'au moins un deuxième segment partiel de la succession de couches semi-conductrices, électriquement isolé de celui-ci, lesquels sont prévus pour émettre un rayonnement électromagnétique en direction vers un premier côté principal ;
- réalisation d'un premier plan conducteur (405) sur un côté de la succession de couches semi-conductrices, détourné du premier côté principal, et mise en contact de la couche active du premier segment partiel ;
- réalisation d'un deuxième plan conducteur (415) sur le côté de la succession de couches semi-conductrices, détourné du premier côté principal, et mise en contact de la couche active de l'au moins un deuxième segment partiel ;
- réalisation d'au moins un troisième plan conducteur (425) sur le côté de la succession de couches semi-conductrices, détourné du premier côté principal, et mise en contact de la couche active du premier segment partiel et de la couche active de l'au moins un deuxième segment partiel, le troisième plan conducteur couplant entre elles les couches actives des au moins deux segments partiels en formant un circuit en série ;
- disposition d'un substrat de support sur le côté de la succession de couches semi-conductrices, détourné du premier côté principal, le premier, le deuxième et le troisième plans conducteurs étant disposés au moins en partie entre un substrat de support et la succession de couches semi-conductrices ;
- réalisation d'un premier plot de contact (40) qui est relié au premier plan conducteur ;
- réalisation d'un deuxième plot de contact (41) qui est relié au deuxième plan conducteur ;
- réalisation d'au moins un troisième plot de contact (42) qui est relié à l'au moins un troisième plan conducteur, au moins un du premier, du deuxième et du troisième plans conducteurs et un autre plan conducteur du premier, du deuxième et du troisième plans conducteur se chevauchant et étant séparés par une couche d'isolation (501 - 503).

12. Procédé selon la revendication 11, dans lequel une croissance épitaxiale comprend :
- une application d'une couche réfléchissante sur un côté de la succession de couches semi-conductrices, détourné du premier côté principal.

13. Procédé selon l'une quelconque des revendications 11 à 12, dans lequel la croissance épitaxiale comprend
- la fourniture d'un substrat de croissance ;
- la croissance épitaxiale d'une première couche partielle ayant un premier type de dopage ;
- la croissance épitaxiale sur la première couche partielle d'une deuxième couche partielle ayant un deuxième type de dopage, de sorte que la couche active se forme entre la première et la deuxième couches partielles.

14. Procédé selon l'une quelconque des revendications 11 à 13, dans lequel la réalisation d'au moins un du premier, du deuxième et d'au moins un troisième plans conducteurs comprend une application d'un matériau isolant et la structuration suivante du matériau isolant appliqué.
